(19) **Europäisches Patentamt European Patent Office Office européen des brevets**

(11) **EP 4 023 363 B1**

(12) **EUROPEAN PATENT SPECIFICATION**

(45) Date of publication and mention of the grant of the patent:
**07.02.2024 Bulletin 2024/06**

(51) International Patent Classification (IPC):
**B22F 1/052** (2022.01)   **H01B 1/22** (2006.01)
**B22F 1/0545** (2022.01)   **B22F 1/054** (2022.01)
**B22F 1/068** (2022.01)   **B22F 1/00** (2022.01)
**B22F 1/107** (2022.01)   **B22F 1/145** (2022.01)
**B22F 7/06** (2006.01)   **B22F 7/08** (2006.01)
**C22C 1/04** (2023.01)   **H01L 23/00** (2006.01)
**B22F 7/04** (2006.01)   **H01L 23/31** (2006.01)
**H05K 3/32** (2006.01)

(21) Application number: **20872157.1**

(22) Date of filing: **30.09.2020**

(52) Cooperative Patent Classification (CPC):
(C-Sets available)
**B22F 1/052; B22F 1/00; B22F 1/0545; B22F 1/056;
B22F 1/068; B22F 1/09; B22F 1/107; B22F 1/147;
B22F 7/062; B22F 7/08; C22C 1/0425; H01B 1/22;
H01L 24/13; H01L 24/29; H01L 24/40;** (Cont.)

(86) International application number:
**PCT/JP2020/037198**

(87) International publication number:
**WO 2021/066026 (08.04.2021 Gazette 2021/14)**

(54) **COPPER PASTE FOR JOINING AND METHOD FOR MANUFACTURING JOINED BODY**

KUPFERPASTE ZUM VERBINDEN UND VERFAHREN ZUR HERSTELLUNG EINES VERBUNDENEN KÖRPERS

PÂTE DE CUIVRE POUR LIAISON ET PROCÉDÉ DE FABRICATION D'UN CORPS PAR LIAISON

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2019 JP 2019179791**

(43) Date of publication of application:
**06.07.2022 Bulletin 2022/27**

(73) Proprietor: **Resonac Corporation**
**Tokyo, 1058518 (JP)**

(72) Inventors:
• **KAWANA, Yuki**
**Tokyo 100-6606 (JP)**
• **EJIRI, Yoshinori**
**Tokyo 100-6606 (JP)**
• **NAKAKO, Hideo**
**Tokyo 100-6606 (JP)**
• **NATORI, Michiko**
**Tokyo 100-6606 (JP)**
• **NEGISHI, Motohiro**
**Tokyo 100-6606 (JP)**
• **ISHIKAWA, Dai**
**Tokyo 100-6606 (JP)**
• **SUGAMA, Chie**
**Tokyo 100-6606 (JP)**

(74) Representative: **Kraus & Lederer**
**Patentanwälte PartGmbB**
**Thomas-Wimmer-Ring 15**
**80539 München (DE)**

(56) References cited:
**WO-A1-2018/168187       WO-A1-2019/093121
JP-A- 2013 221 143       JP-A- 2017 119 291
JP-A- 2017 130 623       JP-A- 2018 107 421
JP-A- 2018 152 176       JP-A- 2018 170 228
JP-A- 2018 170 228       JP-A- 2019 055 414**

**JP-A- 2019 057 691**

Remarks:

The file contains technical information submitted after the application was filed and not included in this specification

(52) Cooperative Patent Classification (CPC): (Cont.)
**H01L 24/81; H01L 24/83; H01L 24/84;**
B22F 2007/047; H01L 23/3107; H01L 24/48;
H01L 24/73; H01L 24/92; H01L 2224/13082;
H01L 2224/13118; H01L 2224/13139;
H01L 2224/13144; H01L 2224/13147;
H01L 2224/13155; H01L 2224/13164;
H01L 2224/13169; H01L 2224/1329;
H01L 2224/13294; H01L 2224/13339;
H01L 2224/13344; H01L 2224/13347;
H01L 2224/13355; H01L 2224/13364;
H01L 2224/13369; H01L 2224/1349;
H01L 2224/13491; H01L 2224/13493;
H01L 2224/16145; H01L 2224/16146;
H01L 2224/2929; H01L 2224/29294;
H01L 2224/29339; H01L 2224/29344;
H01L 2224/29347; H01L 2224/29355;
H01L 2224/29364; H01L 2224/29369;
H01L 2224/2949; H01L 2224/29491;
H01L 2224/29493; H01L 2224/32245;
H01L 2224/37147; H01L 2224/40095;
H01L 2224/40245; H01L 2224/40499;
H01L 2224/45099; H01L 2224/48091;
H01L 2224/48247; H01L 2224/73221;
H01L 2224/73265; H01L 2224/81418;
H01L 2224/81439; H01L 2224/81444;
H01L 2224/81447; H01L 2224/81455;
H01L 2224/81464; H01L 2224/81469;
H01L 2224/83447; H01L 2224/8384;
H01L 2224/84447; H01L 2224/8484;
H01L 2224/92247; H01L 2924/00014;
H01L 2924/181; H05K 3/32

C-Sets
H01L 2224/13118, H01L 2924/00014;
H01L 2224/13139, H01L 2924/00014;
H01L 2224/13144, H01L 2924/00014;
H01L 2224/13147, H01L 2924/01201;
H01L 2224/13155, H01L 2924/00014;
H01L 2224/13164, H01L 2924/00014;
H01L 2224/13169, H01L 2924/00014;
H01L 2224/1329, H01L 2924/06;
H01L 2224/13339, H01L 2924/00014;
H01L 2224/13344, H01L 2924/00014;
H01L 2224/13347, H01L 2924/00014;
H01L 2224/13355, H01L 2924/00014;
H01L 2224/13364, H01L 2924/00014;
H01L 2224/13369, H01L 2924/00014;
H01L 2224/1349, H01L 2924/061,
H01L 2924/00014;
H01L 2224/1349, H01L 2924/0625,
H01L 2924/00014;
H01L 2224/13491, H01L 2924/0715,
H01L 2924/00014;
H01L 2224/2929, H01L 2924/06;
H01L 2224/29339, H01L 2924/00014;
H01L 2224/29344, H01L 2924/00014;
H01L 2224/29347, H01L 2924/00014;
H01L 2224/29355, H01L 2924/00014;
H01L 2224/29364, H01L 2924/00014;
H01L 2224/29369, H01L 2924/00014;

H01L 2224/2949, H01L 2924/061,
H01L 2924/00014;
H01L 2224/2949, H01L 2924/0625,
H01L 2924/00014;
H01L 2224/29491, H01L 2924/0715,
H01L 2924/00014;
H01L 2224/37147, H01L 2924/00014;
H01L 2224/40499, H01L 2924/01028,
H01L 2924/00014;
H01L 2224/40499, H01L 2924/01029,
H01L 2924/00014;
H01L 2224/40499, H01L 2924/01046,
H01L 2924/00014;
H01L 2224/40499, H01L 2924/01047,
H01L 2924/00014;
H01L 2224/40499, H01L 2924/01078,
H01L 2924/00014;
H01L 2224/40499, H01L 2924/01079,
H01L 2924/00014;
H01L 2224/40499, H01L 2924/06;
H01L 2224/40499, H01L 2924/061,
H01L 2924/00014;
H01L 2224/40499, H01L 2924/0625,
H01L 2924/00014;
H01L 2224/40499, H01L 2924/0715,
H01L 2924/00014;
H01L 2224/45099, H01L 2924/00014;
H01L 2224/48091, H01L 2924/00014;
H01L 2224/73221, H01L 2224/40245,
H01L 2224/48247, H01L 2924/00;
H01L 2224/73265, H01L 2224/32245,
H01L 2224/48247, H01L 2924/00012;
H01L 2224/81418, H01L 2924/00014;
H01L 2224/81439, H01L 2924/00014;
H01L 2224/81444, H01L 2924/00014;
H01L 2224/81447, H01L 2924/01201;
H01L 2224/81455, H01L 2924/00014;
H01L 2224/81464, H01L 2924/00014;
H01L 2224/81469, H01L 2924/00014;
H01L 2224/83447, H01L 2924/00014;
H01L 2224/84447, H01L 2924/00014;
H01L 2224/92247, H01L 2224/73265,
H01L 2224/32245, H01L 2224/48247,
H01L 2924/00012;
H01L 2924/00014, H01L 2224/45099;
H01L 2924/00014, H01L 2224/73221;
H01L 2924/181, H01L 2924/00012

## Description

## Technical Field

The present invention relates to a copper paste for joining and a method for manufacturing a joined body.

## Background Art

In general, solder joining is used for electrical joining in electronic devices. For example, in flip-chip joining of microdevices, solder balls, solder paste, and the like are used for joining microdevices and electrode pads on a substrate.

In recent years, in the flip-chip joining, with the narrower pitch of terminals, a method of forming a metal pillar on a microdevice and solder-joining the metal pillar and an electrode pad on a substrate has been used. However, in solder joining, there are problems such as (1) occurrence of Kirkendall voids between the solder and the electrode pad and between the solder and the metal pillar, (2) occurrence of joining failure caused by the solder being melted in the case of performing a reflow process again after joining, and (3) occurrence of signal reflection caused by impedance mismatch at a dissimilar metal interface.

On the other hand, a method has been studied in which joining is performed using a metal other than the solder. For example, in Patent Literature 1 below, a method has been proposed in which joining between a copper pillar provided on a microdevice and a copper pad on a substrate is performed using a joining agent (copper paste) obtained by mixing copper microparticles and copper nanoparticles.

JP 2018 170228 A relates to the problem to provide a conductor-forming composition that can form a conductor at a low temperature (for example, 250°C or less) and can be used as a metal joint material. As a solution to the problem, the document describes a conductor-forming composition which contains a copper-containing particle, an organic acid, and a dispersion medium. The copper-containing particle has a core particle containing copper, and organic matter coating at least a part of a surface of the core particle. The organic matter contains alkyl amine having a hydrocarbon group with the number of carbon atoms being 7 or less.

JP 2018 152176 A relates to the problem to provide a copper paste for bonding that has excellent thermal conductivity and connection reliability, and enables a semiconductor element to be bonded to a semiconductor element mounting support member in a convenient process. As a solution to the problem, the document describes a copper paste for bonding which contains copper particles, pyrolytic resin, and a solvent. The content of the copper particles is 65 mass% or more based on the total mass of the copper paste for bonding, and the content of the pyrolytic resin is 1 mass% or more based on the total mass of the copper particles and the pyrolytic resin.

## Citation List

## Patent Literature

Patent Literature 1: US Patent Application Publication No. 2016/0351529

## Summary of Invention

## Technical Problem

However, in the joining using the copper paste, in order to obtain a sufficient joining strength, it is necessary to thermocompression bonding members to be joined under a high pressure or to heat the copper paste under a reducing gas atmosphere containing hydrogen gas or the like. In thermocompression bonding under a high pressure, a load is applied to members to be joined, which may cause problems such as a decrease in mass production yield ratio and a decrease in long-term reliability. On the other hand, in the case of heating under a reducing gas atmosphere, it is desirable to reduce a hydrogen concentration so that it is not necessary to make a facility to be used explosion-proof, etc. and it is further desirable to change the gas atmosphere to an inert gas atmosphere such as nitrogen gas. However, in order to obtain a sufficient joining strength without applying a load to members to be joined, the conventional copper paste is not sufficient, and further improvement is required.

The present invention has been made in view of the above-described circumstances, and an object thereof is to provide a copper paste for joining capable of obtaining a sufficient joining strength even in the case of heating the copper paste for joining under a gas atmosphere not containing hydrogen or a gas atmosphere having a low hydrogen concentration, and a method for manufacturing a joined body using the copper paste for joining.

**Solution to Problem**

The present invention provides the copper paste for joining defined in claim 1, and the method for manufacturing a joined body defined in claim 3. Preferred embodiments of the invention are defined in the dependent claims.

According to the above-described copper paste for joining, it is possible to obtain a sufficient joining strength even in the case of heating the copper paste for joining under a gas atmosphere not containing hydrogen or a gas atmosphere having a low hydrogen concentration. Thereby, the above-described copper paste for joining can also be applied to a joining apparatus that is not explosion-proof.

The reason why such effects are obtainable is not clear, but one of factors thereof is considered that a protective material of the surfaces of copper particles is effectively desorbed during heating the copper paste. That is, the present inventors have speculated that, since a polycarboxylic acid having a melting point of 120°C or lower (namely a dimethylglutaric acid) flows when the copper paste is heated so that the polycarboxylic acid can be sufficiently contacted with copper particles, and a strong interaction between the carboxyl group and the protective material of the surfaces of the copper particles is produced, sintering of the copper particles is sufficiently performed even in nitrogen or under a gas atmosphere having a low hydrogen concentration.

The content of the polycarboxylic acid (namely the dimethylglutaric acid) in the copper paste for joining is 0.05 to 1.5% by mass on the basis of the total amount of the copper particles. In this case, it is possible to achieve both the storage stability and the joining strength of the copper paste for joining.

The copper paste for joining contains dihydroterpineol as the dispersion medium. In this case, it is possible to achieve both of the printing property and the joining strength of the paste in a high level.

The copper paste for joining contains submicro copper particles having a volume average particle diameter of 0.12 to 0.8 $\mu$m and flake-shaped micro copper particles having a maximum diameter of 2 to 50 $\mu$m and an aspect ratio of 3.0 or more as the copper particles. This case is suitable for joining under non-pressurization.

Note that, the term "non-pressurization" in the present specification means a state in which the copper paste for joining receives only the weight of a member to be joined or receives a micropressure of 0.01 MPa or less (in other words, a pressure at the time of joining is 0.01 MPa or less) in addition to the weight thereof.

The content of the submicro copper particles in the copper paste for joining is 30 to 90% by mass on the basis of the total mass of the copper particles, and the content of the micro copper particles may be 10 to 70% by mass on the basis of the total mass of the copper particles.

The copper paste for joining is for non-pressurization joining.

Another aspect of the present invention relates to a method for manufacturing a joined body as defined in claim 3. According to this manufacturing method, it is possible to obtain a joined body having a sufficient joining strength by using the above-described copper paste for joining and heating under the above-described gas atmosphere. Furthermore, the above-described manufacturing method can also be executed in a joining apparatus that is not explosion-proof.

Note that, the hydrogen concentration in the gas atmosphere in the present specification means a volume ratio (%) of hydrogen contained in the whole gas inside a manufacturing apparatus.

The gas atmosphere may be a nitrogen gas atmosphere. Even in the case of heating the joining precursor in such an atmosphere, a joined body having a sufficient joining strength can be obtained.

In the second step, the copper paste for joining is heated and sintered in a state of receiving a weight of the first member or in a state of receiving a weight of the first member and a micropressure of 0.01 MPa or less. In this case, it is possible to reduce damages to a member to be joined by non-pressurization joining.

At least one of the first member and the second member may be a semiconductor element. In this case, a semiconductor device can be obtained as the joined body.

In the laminate, the first member may have a first electrode, the second member may have a second electrode facing the first electrode, and the copper paste for joining may be provided between the first electrode and the second electrode. In this case, a joined body in which the first electrode and the second electrode are joined with a sufficient joining strength.

At least one of the first electrode and the second electrode may be a metal pillar. In this case, a joined body obtained by pillar-joining can be obtained.

The first member and the second member may be wafers or chips including one or two or more semiconductors selected from the group consisting of silicon, gallium nitride, and silicon carbide, and the first electrode and the second electrode may be through electrodes. According to this method, it is possible to obtain, as the joined body, a semiconductor device which is a laminate of a plurality of semiconductor wafers and/or semiconductor chips provided with through electrodes and in which layers are microbump-joined.

Also described in here (but not claimed as such) is a joined body including: a first member; a second member; and a sintered body of the above-described copper paste for joining that joins the first member and the second member.

At least one of the first member and the second member may be a semiconductor element. That is, the joined body may be a semiconductor device.

In the joined body, the first member may have a first electrode, the second member may have a second electrode facing the first electrode, and the sintered body of the copper paste for joining may join the first electrode and the second electrode.

At least one of the first electrode and the second electrode may be a metal pillar.

The first member and the second member may be wafers or chips including one or two or more semiconductors selected from the group consisting of silicon, gallium nitride, and silicon carbide, and the first electrode and the second electrode may be through electrodes.

**Advantageous Effects of Invention**

According to the present invention, it is possible to provide a copper paste for joining capable of obtaining a sufficient joining strength even in the case of heating the copper paste for joining under a gas atmosphere not containing hydrogen or a gas atmosphere having a low hydrogen concentration, and a method for manufacturing a joined body using the copper paste for joining and a joined body.

**Brief Description of Drawings**

FIG. 1 is a schematic cross-sectional view illustrating a method for manufacturing a joined body of an embodiment.

FIG. 2 is a schematic cross-sectional view for describing a first step in the method for manufacturing a joined body.

FIG. 3 is a schematic cross-sectional view for describing the first step in the method for manufacturing a joined body.

FIG. 4 is a schematic cross-sectional view illustrating an example of a joined body manufactured by using a copper paste for joining of the present embodiment.

FIG. 5 is a schematic cross-sectional view illustrating an example of a semiconductor device manufactured by using the copper paste for joining of the present embodiment.

FIG. 6 is a schematic cross-sectional view for describing a method for manufacturing the joined body illustrated in FIG. 4.

FIG. 7 is a schematic cross-sectional view for describing a method for manufacturing the semiconductor device illustrated in FIG. 5.

FIG. 8 is a schematic cross-sectional view illustrating an example of a joined body manufactured by using the copper paste for joining of the present embodiment.

FIG. 9 is a schematic cross-sectional view for describing a method for manufacturing the joined body illustrated in FIG. 8.

FIG. 10 is a schematic cross-sectional view illustrating an example of a joined body manufactured by using the copper paste for joining of the present embodiment.

FIG. 11 is a schematic cross-sectional view for describing a method for manufacturing the joined body illustrated in FIG. 10.

FIG. 12 is a schematic cross-sectional view for describing a joined body in which TSV chip layers are microbump-joined and a manufacturing method therefor.

**Description of Embodiments**

Hereinafter, embodiments of the present invention will be specifically described. However, the present invention is not limited to the following embodiments.

First, the details of a copper paste for joining of the present embodiment will be described.

<Copper paste for joining>

The copper paste for joining of the present invention is defined in claim 1. Note that, in the present specification, for convenience sake, the aggregation of a plurality of copper particles is also referred to as "copper particles". The same applies to metal particles other than the copper particles.

(Copper particles)

The the copper paste for joining includes submicro copper particles as defined in claim 1, flake-shaped micro copper particles as defined in claim 1, and may contain copper particles other than these.

[Submicro copper particles]

The submicro copper particles are copper particles having a particle diameter of 0.12 $\mu$m or more and less than 0.8 $\mu$m. The submicro copper particles preferably have sinterability in a temperature range of 150°C or higher and 300°C or lower. The particle diameter of the copper particles can be calculated, for example, from an SEM image. A powder of the copper particles is placed on carbon tape for SEM using a spatula, thereby producing a sample for SEM. This sample for SEM is observed using an SEM apparatus at a magnification of 5000 times. A rectangle circumscribing the copper particle in this SEM image is drawn using image processing software, and the one side of the rectangle is considered as the particle diameter of the particle.

When the volume average particle diameter of the submicro copper particles is 0.12 $\mu$m or more, it becomes easy to obtain effects of the suppression of the synthesis cost of the submicro copper particles, favorable dispersibility, and the suppression of the amount of a surface treatment agent used. When the volume average particle diameter of the submicro copper particles is 0.80 $\mu$m or less, it becomes easy to obtain an effect of the submicro copper particles being excellent in terms of the sinterability. From the viewpoint of even further exhibiting the above-described effect, the volume average particle diameter of the submicro copper particles may be 0.15 $\mu$m or more, 0.2 $\mu$m or more, or 0.3 $\mu$m or more. Furthermore, from the viewpoint of even further exhibiting the above-described effect, the volume average particle diameter of the submicro copper particles may be 0.60 $\mu$m or less, 0.50 $\mu$m or less, 0.45 $\mu$m or less, or 0.40 $\mu$m or less. The volume average particle diameter of the submicro copper particles may be, for example, 0.15 to 0.80 $\mu$m, 0.15 to 0.60 $\mu$m, 0.20 to 0.50 $\mu$m, 0.30 to 0.45 $\mu$m, or 0.30 to 0.40 $\mu$m.

The volume average particle diameter in the present specification means a 50% volume average particle diameter. The volume average particle diameter of the metal particles (for example, copper particles) is measured by the following method. First, metal particles serving as a raw material or dried metal particles obtained by removing a volatile component from the metal paste are dispersed in a dispersion medium by using a dispersant. Next, the volume average particle diameter of the obtained dispersion element is measured by a light scattering-method particle size distribution analyzer (for example, Shimadzu nano particle size distribution analyzer (SALD-7500nano, manufactured by SHIMADZU CORPORATION)). In the case of using a light scattering-method particle size distribution analyzer, as the dispersion medium, hexane, toluene, $\alpha$-terpineol, 4-methyl-1,3-dioxolan-2-one, and the like can be used.

The shape of the submicro copper particles is not particularly limited. Examples of the shape of the submicro copper particles include a spherical shape, a block shape, a needle shape, a columnar shape, a flake shape, a substantially spherical shape, and an aggregate thereof. From the viewpoint of dispersibility and fillability, the shape of the submicro copper particles may be a spherical shape, a substantially spherical shape, or a flake shape, and from the viewpoint of combustibleness, dispersibility, a property of mixing with a flake-shaped micro particles (for example, flake-shaped micro copper particles), and the like, the shape of the submicro copper particles may be a spherical shape or a substantially spherical shape. In the present specification, the "flake shape" includes flat plate-like shapes such as a plate shape and a scale shape.

The aspect ratio of the submicro copper particles may be 5.0 or less, may be 3.0 or less, may be 2.5 or less, or may be 2.0 or less, from the viewpoint of dispersibility, fillability, and mixability with flake-shaped micro particles (for example, flake-shaped micro copper particles). In the present specification, the term "aspect ratio" represents a ratio of "a long side of particles/a thickness of particles". The long side of particles and the thickness of particles can be obtained, for example, from an SEM image of particles.

From the viewpoint of the dispersibility of the submicro copper particles, the submicro copper particles may be treated with a surface treatment agent. The surface treatment agent may be, for example, adsorbed on the surface of the submicro copper particles by a hydrogen bond or the like, or may react with the submicro copper particles to bond to the surface of the submicro copper particles. That is, the submicro copper particles may have a compound derived from a specific surface treatment agent. The surface treatment agent is included in an organic compound contained in the copper paste for joining.

Examples of the surface treatment agent include organic acids having 2 to 18 carbon atoms. Examples of the organic acids having 2 to 18 carbon atoms include saturated fatty acids such as acetic acid, propanoic acid, butanoic acid, pentanoic acid, hexanoic acid, heptanoic acid, caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, heptadecanoic acid, octadecanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, sapienic acid, oleic acid, vaccenic acid, linolic acid, linoleic acid, and linolenic acid; and aromatic carboxylic acids such as terephthalic acid, pyromellitic acid, o-phenoxybenzoic acid, methylbenzoic acid, ethylbenzoic acid, propylbenzoic acid, butylbenzoic acid, pentylbenzoic acid, hexylbenzoic acid, heptylbenzoic acid, octylbenzoic acid, and nonylbenzoic acid. The organic acids may be used alone or in combination of two or more kinds thereof. By combining such an organic acid and the above-described submicro copper particles, there is a tendency that both the dispersibility of the submicro copper particles and removal properties of the organic acid during sintering can be achieved.

The treatment amount of the surface treatment agent may be 0.07 to 2.10% by mass, 0.10 to 1.60% by mass, or 0.20 to 1.10% by mass, on the basis of the total mass of the submicro copper particles after the surface treatment, from the viewpoint of the dispersibility of the submicro copper particles. The treatment amount of the surface treatment agent may be 0.07% by mass or more, 0.10% by mass or more, or 0.20% by mass or more, on the basis of the total mass of the submicro copper particles after the surface treatment. The treatment amount of the surface treatment agent may be 2.10% by mass or less, 1.60% by mass or less, or 1.10% by mass or less, on the basis of the total mass of the submicro copper particles after the surface treatment.

The treatment amount of the surface treatment agent may be an amount in which one molecule layer to three molecule layers of the surface treatment agent are attached to the surfaces of the submicro copper particles. This treatment amount is measured by the following method. W1 (g) of the surface-treated submicro copper particles is weighed into an alumina crucible (for example, manufactured by AS ONE Corporation, Model No.: 1-7745-07) treated at 700°C for 2 hours in air and then sintered at 700°C for 1 hour in air. Thereafter, the treatment is performed at 300°C for 1 hour in hydrogen and a mass W2 (g) of the copper particles in the crucible is measured. Next, the treatment amount of the surface treatment agent is calculated on the basis of the following equation.

$$\text{Treatment amount (\% by mass) of surface treatment agent} = (W1 - W2)/W1 \times 100$$

As the submicro copper particles, commercially available submicro copper particles can be used. Examples of materials containing commercially available submicro copper particles include CH-0200 (manufactured by MITSUI MINING & SMELTING CO., LTD., volume average particle diameter 0.36 $\mu$m), HT-14 (manufactured by MITSUI MINING & SMELTING CO., LTD., volume average particle diameter 0.41 $\mu$m), CT-500 (manufactured by MITSUI MINING & SMELTING CO., LTD., volume average particle diameter 0.72 $\mu$m), Tn-Cu100 (manufactured by TAIYO NIPPON SANSO CORPORATION, volume average particle diameter 0.12 $\mu$m), and Cu-C-40 (manufactured by Fukuda Metal Foil & Powder Co., Ltd., volume average particle diameter 0.2 $\mu$m).

The content of the submicro copper particles may be 35% by mass or more, 40% by mass or more, or 50% by mass or more, or may be or 85% by mass or less, on the basis of the total mass of the metal particles contained in the copper paste for joining. Furthermore, the content of the submicro copper particles may be 35 to 90% by mass, 40 to 85% by mass, or 50 to 85% by mass, on the basis of the total mass of the metal particles contained in the copper paste for joining. When the content of the submicro copper particles is within the above range, it becomes easy to ensure the joining strength of a joined body that is manufactured by sintering the copper paste for joining. In the case of using the copper paste for joining in the joining of a microdevice, there is a tendency that the microdevice shows favorable die shear strength and connection reliability.

[Micro copper particles]

The micro copper particles are copper particles having a particle diameter of 2 $\mu$m or more and less than 50 $\mu$m as further defined in claim 1.

The volume average particle diameter of the micro copper particles is preferably 2.0 to 50 $\mu$m. When the volume average particle diameter of the micro copper particles is within the above range, it is possible to reduce volume shrinkage, occurrence of voids, and the like when the copper paste for joining has been sintered, and it becomes easy to ensure the joining strength of a joined body that is manufactured by sintering the copper paste for joining. In the case of using the copper paste for joining in the joining of a microdevice, there is a tendency that the microdevice shows favorable die shear strength and connection reliability. From the viewpoint of even further exhibiting the above-described effect, the volume average particle diameter of the micro copper particles may be 2.0 to 20 $\mu$m, 2.0 to 10 $\mu$m, 3.0 to 20 $\mu$m, or 3.0 to 10 $\mu$m. The volume average particle diameter of the micro copper particles may be 2.0 $\mu$m or more or 3.0 $\mu$m or more. The volume average particle diameter of the micro copper particles may be 50 $\mu$m or less, 20 $\mu$m or less, or 10 $\mu$m or less.

The micro copper particles are flake-shaped.

By using the flake-shaped micro copper particles, the micro copper particles in the copper paste for joining are oriented in approximately parallel to a joining surface, and thus the volume shrinkage in a joining surface direction when the copper paste for joining is sintered can be suppressed and it becomes easy to ensure the joining strength of a joined body that is manufactured by sintering the copper paste for joining. In the case of using the copper paste for joining in the joining of a microdevice, there is a tendency that the microdevice shows favorable die shear strength and connection reliability. From the viewpoint of even further exhibiting the above-described effect, the aspect ratio of the flake-shaped micro copper particles is 3.0 or more, preferably 4.0 or more, and further preferably 6.0 or more.

The maximum diameter and the average maximum diameter of the flake-shaped micro copper particles may be 3.0 to 50 $\mu$m, or 3.0 to 20 $\mu$m. The maximum diameter and the average maximum diameter of the flake-shaped micro copper particles is obtained from SEM images of the particles. The maximum diameter and the average maximum diameter of the flake-shaped micro copper particles are obtained as a major axis X and an average value Xav of the major axis of the flake-shaped micro copper particles. The major axis X is a distance of two parallel planes that are selected so that the distance between two parallel planes is the largest among two parallel planes circumscribing the flake-shaped micro copper particles in the three-dimensional shape of the flake-shaped micro copper particles.

In the micro copper particles, there is no particular limitation as to whether or not to perform a treatment with the surface treatment agent. From the viewpoints of dispersion stability and oxidation resistance, the micro copper particles may be treated with a surface treatment agent. That is, the micro copper particles may have a compound derived from a surface treatment agent. The surface treatment agent may be adsorbed on the surface of the micro copper particles by a hydrogen bond or the like, or may react with the micro copper particles to bond to the surface of the micro copper particles.

The surface treatment agent may be removed by heating during joining. Examples of such a surface treatment agent include aliphatic carboxylic acids such as dodecanoic acid, palmitic acid, heptadecanoic acid, stearic acid, arachidic acid, linolic acid, linoleic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohols such as p-phenyl phenol; alkylamines such as octylamine, dodecylamine, and stearylamine; aliphatic nitriles such as stearonitrile and decanenitrile; silane coupling agents such as alkylalkoxysilane; and polymer treatment agents such as polyethylene glycol, polyvinyl alcohol, polyvinyl pyrrolidone, and silicone oligomer. The surface treatment agent may be used alone or in combination of two or more kinds thereof.

As the micro copper particles, commercially available submicro copper particles can be used. Examples of materials containing commercially available micro copper particles include 1050YF (manufactured by MITSUI MINING & SMELTING CO., LTD., volume average particle diameter 1.7 $\mu$m, MA-C025KFD (manufactured by MITSUI MINING & SMELTING CO., LTD., volume average particle diameter 7.5 $\mu$m), 3L3 (manufactured by Fukuda Metal Foil & Powder Co., Ltd., volume average particle diameter 8.0 $\mu$m), 2L3N (manufactured by Fukuda Metal Foil & Powder Co., Ltd., volume average particle diameter 7.2 $\mu$m), and 1110F (manufactured by MITSUI MINING & SMELTING CO., LTD., volume average particle diameter 3.8 $\mu$m).

The content of the micro copper particles may be 15% by mass or more, or 20% by mass or more, and may be 50% by mass or less, 45% by mass or less, or 40% by mass or less, on the basis of the total mass of the metal particles contained in the copper paste for joining. Furthermore, the content of the micro copper particles may be 10 to 65% by mass, 10 to 50% by mass, 15 to 60% by mass, 15 to 50% by mass, or 15 to 45% by mass, on the basis of the total mass of the metal particles contained in the copper paste for joining. When the content of the micro copper particles is within the above range, peeling of a joining portion (for example, a sintered body) and occurrence of voids and cracks are suppressed so that the joining strength can be ensured. In the case of using the copper paste for joining in the joining of a microdevice, there is a tendency that the microdevice shows favorable die shear strength and connection reliability.

The content of the flake-shaped micro copper particles may be the same as the range of the content of the micro copper particles described above. In a case where the content of the flake-shaped micro copper particles is in such a range, there is a tendency that the above-described effect is even further exhibited.

[Other copper particles]

Examples of copper particles other than the submicro copper particles and the micro copper particles include copper nanoparticles. The copper nanoparticles indicate copper particles having a particle diameter of less than 0.01 μm. The surfaces of the copper nanoparticles are generally coated with carboxylic acid or amine (referred to as a surface coating material). The copper nanoparticles have a larger specific surface area than copper micro particles, the ratio of the surface coating material occupied per unit mass tends to increase. Therefore, since the surface coating material to be desorbed during stirring (during heating) is increased, volume shrinkage during stirring tends to increase as compared to the copper micro particles. From the viewpoint of reducing volume shrinkage, the content of the copper nanoparticles is preferably 30% by mass or less and more preferably 15% by mass or less on the basis of the total mass of the copper particles, and it is further preferable that the copper nanoparticles are not contained.

The copper paste for joining of the present invention contains submicro copper particles and micro copper particles as defined in claim 1. In the case of using submicro copper particles and micro copper particles together, volume shrinkage and sintering shrinkage along with drying are easily suppressed, and the copper paste for joining is less likely to be peeled off from a joining surface during sintering. That is, by using submicro copper particles and micro copper particles together, volume shrinkage when the copper paste for joining is sintered is suppressed, and the joined body can have a more sufficient joining strength. In the case of using the copper paste for joining, which uses submicro copper particles and micro copper particles together, in joining of a microdevice, the microdevice tends to exhibit more satisfactory die shear strength and connection reliability. Furthermore, the joining portion of such a microdevice can have improved thermal conductivity and electric conductivity.

The sum of the content of the submicro copper particles and the content of the micro copper particles may be 80 to 100% by mass on the basis of the total mass of the metal particles contained in the copper paste for joining. When the sum of the content of the submicro copper particles and the content of the micro copper particles within the above range, it is possible to sufficiently reduce volume shrinkage when the copper paste for joining has been sintered, and it becomes easy to ensure the joining strength of a joined body that is manufactured by sintering the copper paste for joining. In the case of using the copper paste for joining in the joining of a microdevice, there is a tendency that the microdevice shows favorable die shear strength and connection reliability. From the viewpoint of further exhibiting the above-described effect, the sum of the content of the submicro copper particles and the content of the micro copper particles may be 90% by mass or more, may be 95% by mass or more, or may be 100% by mass, on the basis of the total mass of the metal particles.

The copper paste for joining of the present invention contains submicro copper particles having a volume average particle diameter of 0.12 to 0.8 μm and flake-shaped micro copper particles having a maximum diameter of 2 to 50 μm and an aspect ratio of 3.0 or more. This case is suitable for joining under non-pressurization. The content of the submicro copper particles in the copper paste for joining is 30 to 90% by mass on the basis of the total mass of the copper particles, and a content of the micro copper particles is 10 to 70% by mass on the basis of the total mass of the copper particles.

[Other metal particles]

The copper paste for joining of the present embodiment can contain metal particles other than the copper particles (also referred to as "other metal particles").
Examples of the other metal particles include particles of nickel, silver, gold, palladium, platinum, and the like. The volume average particle diameter of the other metal particles may be 0.01 to 10 μm, 0.01 to 5 μm, or 0.05 to 3 μm. The shape of the other metal particles is not particularly limited. The content of the other metal particles may be less than 20% by mass, may be 10% by mass or less, and may be 0% by mass, on the basis of the total mass of the metal particles contained in the copper paste for joining, from the viewpoint of obtaining sufficient joining properties.

(Polycarboxylic acid having melting point of 120°C or lower)

The copper paste for joining contains a dimethylglutaric acid as a polycarboxylic acid having a melting point of 120°C or lower (hereinafter, also referred to as "low-melting-point polycarboxylic acid" in some cases), which is an example of a dicarboxylic acid represented by General Formula (1) below.

$$\text{HOOC-R-COOH} \qquad (1)$$

[In Formula (1), R represents a linear or branched saturated or unsaturated divalent hydrocarbon group having 2 to 10 carbon atoms.]

Examples of the above-described dicarboxylic acid include dimethylglutaric acid (melting point 83°C), which must be contained in the copper paste for joining according to the invention, isopropylmalonic acid (melting point 90°C), allylmalonic acid (melting point 103°C), and ethylmalonic acid (112°C). R described above is preferably a linear or branched alkylene group having 4 to 5 carbon atoms.

From the viewpoint of improving a joining strength when the joining temperature is a low temperature of 200°C or lower, the copper paste for joining contains a polycarboxylic acid having a melting point of 120°C or lower, namely dimethylglutaric acid, and may additionally contain a polycarboxylic acid having a melting point of 115°C or lower, or may contain a polycarboxylic acid having a melting point of 100°C or lower, as the low-melting-point polycarboxylic acid. From the viewpoint of storage stability, the melting point of the low-melting-point polycarboxylic acid may be 30°C or higher or may be 50°C or higher.

The content of the low-melting-point polycarboxylic acid, namely dimethylglutaric acid, in the copper paste for joining may be 0.1 to 1.5% by mass, may be 0.1 to 1% by mass, or may be 0.1 to 0.5% by mass, on the basis of the total amount of the copper particles, from the viewpoint of achieving both of the storage stability and the joining strength of the copper paste for joining.

(Dispersion medium)

The copper paste for joining contains dihydroterpineol as the dispersion medium, which has a function of dispersing metal particles, and a volatile dispersion medium may be used. Examples of additional components of the volatile dispersion medium include alcohols such as monohydric alcohol and polyhydric alcohol, ethers, esters, acid amides, aliphatic hydrocarbons, and aromatic hydrocarbons. Specific examples thereof include alcohols such as cyclohexanol, ethylene glycol, diethylene glycol, propylene glycol, butylene glycol, and α-terpineol; ethers such as diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol dimethyl ether, propylene glycol diethyl ether, propylene glycol dibutyl ether, propylene glycol dipropyl ether, and tripropylene glycol dimethyl ether; esters such as ethylene glycol ethyl ether acetate, ethylene glycol butyl ether acetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; and aromatic hydrocarbons such as benzene, toluene, and xylene.

The content of the dispersion medium may be 5 to 50 parts by mass, may be 5 to 40 parts by mass, or may be 7 to 35 parts by mass, when the total mass of the metal particles contained in the copper paste for joining is regarded as 100 parts by mass. When the content of the dispersion medium is within the above range, it is possible to adjust the copper paste for joining to a more appropriate viscosity, and the sintering of the copper particles is not easily inhibited.

The copper paste for joining of the present invention contains dihydroterpineol from the viewpoint of achieving both of the printing property and the joining strength of the paste in a high level. The content of the dihydroterpineol is 60% by mass or more, or may be 100% by mass, on the basis of the total mass of the dispersion medium.

The copper paste for joining preferably contains a dispersion medium having a boiling point of 300°C or higher. By containing a dispersion medium having a boiling point of 300°C or higher, plasticity and adhesiveness are imparted to the copper paste for joining immediately before the start of sintering, and joining under non-pressurization becomes easy. The boiling point of the dispersion medium having a boiling point of 300°C or higher may be 300 to 450°C, may be 305 to 400°C, or may be 310 to 380°C, from the viewpoint of rapidly evaporating and removing the dispersion medium when the temperature reaches the joining temperature without inhibiting sintering and densification during sintering the copper paste for joining.

Examples of the dispersion medium having a boiling point of 300°C or higher include isobornyl cyclohexanol (MTPH, manufactured by Nippon Terpene Chemicals, Inc.), butyl stearate, EXCEPARL BS (manufactured by Kao Corporation), stearyl stearate, EXCEPARL SS (manufactured by Kao Corporation), 2-ethylhexyl stearate, EXCEPARL EH-S (manufactured by Kao Corporation), isotridecyl stearate, EXCEPARL TD-S (manufactured by Kao Corporation), heptadecane, octadecane, nonadecane, eicosane, heneicosane, docosane, methyl heptadecane, tridecyl cyclohexane, tetradecyl cyclohexane, pentadecyl cyclohexane, hexadecyl cyclohexane, undecyl benzene, dodecyl benzene, tetradecyl benzene, tridecyl benzene, pentadecyl benzene, hexadecyl benzene, heptadecyl benzene, nonyl naphthalene, diphenyl propane, octyl octanoate, methyl myristate, ethyl myristate, methyl linoleate, methyl stearate, triethylene glycol bis(2-ethyl hexanoate), tributyl citrate, dibutyl sebacate, methoxyphenethyl alcohol, benzyl phenol ($C_{13}H_{12}O$), hexadecanenitrile, heptadecanenitrile, benzyl benzoate, cinmethylin, and bis(2-ethylhexyl) adipate. From the viewpoint of more easily performing joining under non-pressurization, the solvent component having a boiling point of 300°C or higher preferably contains at least one selected from the group consisting of isobornyl cyclohexanol, tributyrin, butyl stearate, and octyl octanoate.

The content of the dispersion medium having a boiling point of 300°C or higher may be 2% by mass or more, 2.2% by mass or more, or 2.4% by mass or more, or may be 50% by mass or less, 45% by mass or less, 40% by mass or less, 20% by mass or less, 10% by mass or less, or 5% by mass or less, on the basis of the total mass of the copper paste for joining. For example, the content of the dispersion medium having a boiling point of 300°C or higher may be 2 to 50% by mass on the basis of the total mass of the copper paste for joining.

(Other components)

The copper paste for joining can contain, as additives, a wetting enhancer such as a nonionic surfactant or a fluorine-based surfactant; a surface-tension modifier; a dispersant such as alkylamine or alkylcarboxylic acid; a defoamer such as silicone oil; an ion trapping agent such as an inorganic ion exchanger; and the like. The content of the additive can be appropriately adjusted as long as the effect of the present invention is not impaired. Furthermore, the sum of the contents of non-metallic inorganic particles (for example, glass particles and the like) in the copper paste for joining may be 1% by mass or less or may be 0.1% by mass or less, on the basis of the total amount of the copper particles. Further, the copper paste for joining may not contain non-metallic inorganic particles.

The viscosity of the aforementioned copper paste for joining is not particularly limited, and in the case of coating with a method such as printing, the viscosity may be adjusted to a viscosity suitable for a coating method. The Casson viscosity at 25°C of the copper paste for joining may be 0.05 Pa·s or more or 0.06 Pa·s or more, or may be 2.0 Pa·s or less or 1.0 Pa·s or less. For example, the Casson viscosity at 25°C of the copper paste for joining may be 0.05 to 2.0 Pa·s or may be 0.06 to 1.0 Pa·s.

According to the copper paste for joining of the present invention, it is possible to obtain a sufficient joining strength even in the case of heating the copper paste for joining under a gas atmosphere not containing hydrogen or a gas atmosphere having a low hydrogen concentration. Therefore, the copper paste for joining of the present invention can also be applied to a joining apparatus that is not explosion-proof. Furthermore, the copper paste for joining of the present invention is for non-pressurization joining.

<Preparation of copper paste for joining>

The copper paste for joining can be prepared by mixing the copper particles, the low-melting-point polycarboxylic acid, and the dispersion medium which are described above, and other metal particles and an additive which may be contained depending on circumstances. A stirring treatment may be performed after mixing the respective components. In the copper paste for joining, the maximum particle diameter of a dispersion liquid may be adjusted by a classification operation. At this time, the maximum particle diameter of the dispersion liquid can be set to 20 μm or less, and can also be set to 10 μm or less. As metal particles of the above-described submicro copper particles and the like, those which are treated with a surface treatment agent may be used.

In the case of using submicro copper particles and micro copper particles as the copper particles, the copper paste for joining may be prepared, for example, by the following method. First, a dispersant is added as necessary to the dispersion medium and the low-melting-point polycarboxylic acid, the submicro copper particles are mixed, and then the dispersion treatment is performed. Next, the micro copper particles, and as necessary, other metal particles are added and the dispersion treatment is performed. In the submicro copper particles and the micro copper particles, dispersion methods and dispersion conditions suitable for dispersion may be different. In general, the submicro copper particles are more difficult to disperse than the micro copper particles, and in order to disperse the submicro copper particles, a higher strength than a strength applied when the micro copper particles are dispersed is required. On the other hand, the micro copper particles are not only easy to disperse, but also may deform when a high strength is applied to disperse the micro copper particles. Therefore, with the procedure as described above, satisfactory dispersibility is easily obtainable and the performance of the copper paste for joining can be further improved.

The dispersion treatment can be performed using a disperser or a stirrer. Examples of the disperser and the stirrer include an Ishikawa type stirrer, a Silverson stirrer, a cavitation stirrer, a rotation and revolution-type stirring device, an ultra-thin film high-speed rotation type disperser, an ultrasonic disperser, a Raikai mixer, a twin screw kneader, a bead mill, a ball mill, a three-roll mill, a homomixer, a planetary mixer, an ultrahigh-pressure type disperser, and a thin layer shear disperser.

The classification operation can be performed, for example, by filtration, spontaneous precipitation, and centrifugal separation. Examples of a filter for filtration include a water comb, a metal mesh, a metal filter, and a nylon mesh.

The stirring operation can be performed by using a stirrer. Examples of the stirrer include an Ishikawa type stirrer, a rotation and revolution-type stirring device, a Raikai mixer, a twin screw kneader, a three-roll mill, and a planetary mixer.

<Method for manufacturing joined body>

The method for manufacturing a joined body of the present embodiment is defined in claim 3 and includes: a first step of preparing a laminate in which a first member, the above-described copper paste for joining, and a second member are laminated in this order; and a second step of heating the laminate under a gas atmosphere having a hydrogen concentration of 4.5% or less to sinter the copper paste for joining of the laminate, wherein in the second step, the copper paste for joining is heated and sintered in a state of receiving a weight of the first member or in a state of receiving a weight of the first member and a micropressure of 0.01 MPa or less.

Hereinafter, the method for manufacturing a joined body of the present embodiment will be described with reference to the drawings.

In the method for manufacturing a joined body according to an embodiment, as the above-described laminate, a laminate, which includes a first member having a first electrode, a second member having a second electrode and disposed so that the first electrode and the second electrode face each other, and the above-described copper paste for joining provided between the first electrode and the second electrode, is prepared.

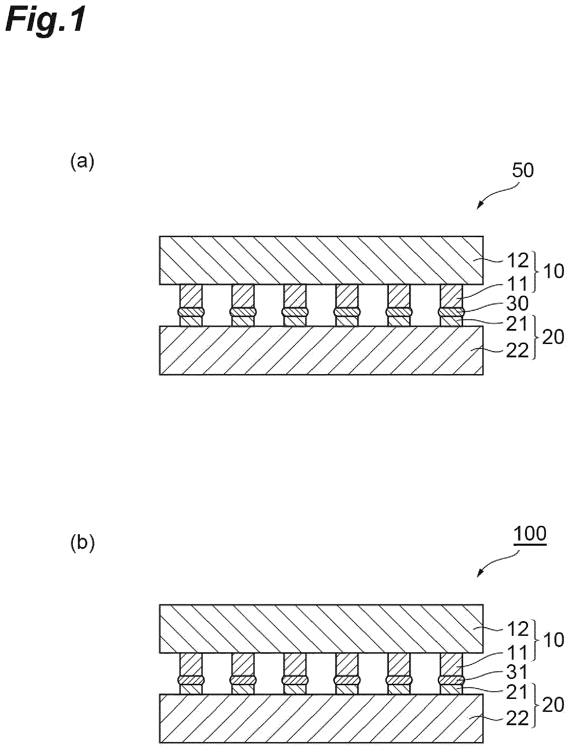

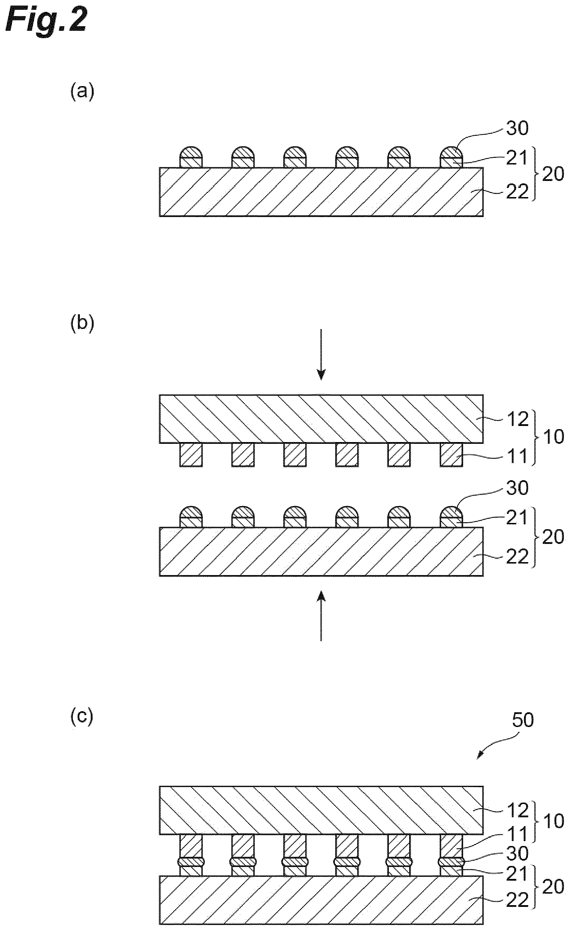

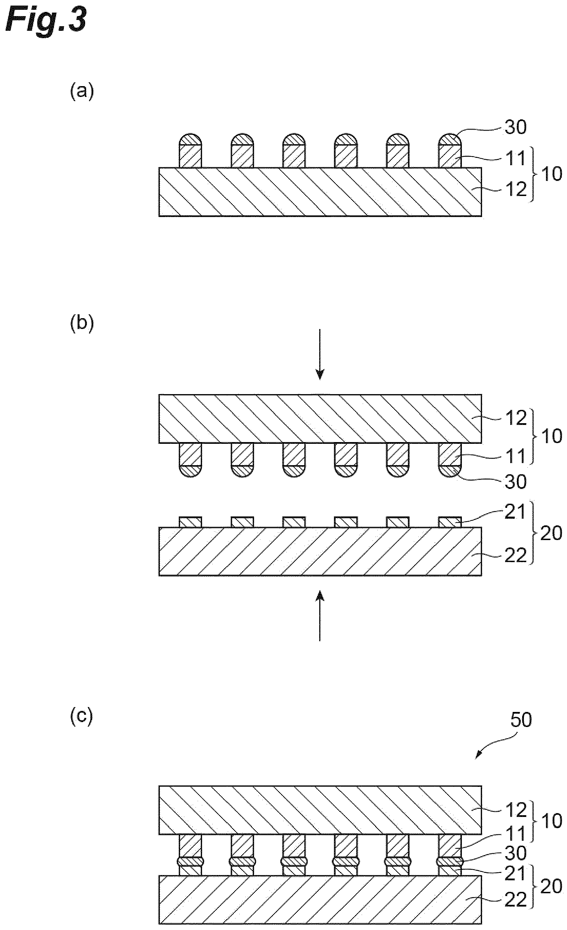

FIG. 1 is a schematic cross-sectional view illustrating a method for manufacturing a joined body of an embodiment. FIG. 2 and FIG. 3 are schematic cross-sectional views illustrating an example of a first step. Herein, a case where the first electrode is a metal pillar and the second electrode is an electrode pad will be illustrated.

(First step)

In the first step, a laminate 50, which includes a first member 10, a second member 20, and a copper paste for joining (joining portion) 30, is prepared (see FIG. 1(a)).

The first member 10 includes a metal pillar 11 and a substrate (first substrate) 12 provided with the metal pillar 11 on one surface thereof. The first member 10 is, for example, a microdevice such as a logic, an analog IC, or a power IC.

A plurality of the metal pillars 11 are provided, for example, on one surface of the first substrate 12, and when the first member 10 and the second member 20 are disposed to face each other, each of the plurality of the metal pillars 11 are disposed on the first substrate 12 to face an electrode pad 21 in the second member 20.

The material for the metal pillar 11 is not particularly limited. In a case where an oxide film is formed on the joining surface of the metal pillar 11 (the surface on which the copper paste for joining 30 is disposed, the surface opposite to the first substrate 12), from the viewpoint of easily removing the oxide film in the second step, at least the joining surface of the metal pillar 11 is preferably made of at least one metal selected from the group consisting of gold, platinum, silver, palladium, copper, nickel, and zinc. Furthermore, from the viewpoint of suppressing Kirkendall voids after joining and the viewpoint of suppressing impedance mismatch, at least the joining surface of the metal pillar 11 is preferably made of a material containing copper, and more preferably made of a material containing copper at a certain ratio or more (for example, 90% by mass or more).

The shape for the metal pillar 11 is not particularly limited. The shape of the cross-section perpendicular to the direction in which the metal pillar 11 extends may be, for example, a circular shape, an elliptical shape, a rectangular shape, or the like. The height of the metal pillar 11 may be, for example, 10 μm or more or may be 100 μm or less. The pillar diameter of the metal pillar 11 (the maximum diameter in the case of the cross-section being a shape other than a circular shape) may be, for example, 10 μm or more or may be 300 μm or less.

The second member 20 includes the electrode pad 21 and a substrate (second substrate) 22 on which the electrode pad 21 is provided on one surface. The second member 20 is, for example, a substrate such as a mounting substrate, a lead frame, a high heat dissipation mounting substrate, a silicon interposer, or an epoxy wiring board.

The shape and material of the electrode pad 21 are not particularly limited. In a case where an oxide film is formed on the joining surface of the electrode pad 21 (the surface on which the copper paste for joining 30 is disposed, the surface opposite to the second substrate 22), from the viewpoint of easily removing the oxide film in the second step, at least the joining surface of the electrode pad 21 is preferably made of at least one metal selected from the group consisting of gold, platinum, silver, palladium, copper, nickel, and zinc. Furthermore, from the viewpoint of suppressing Kirkendall voids after joining and the viewpoint of suppressing impedance mismatch, at least the joining surface of the electrode pad 21 is preferably made of a material containing copper, and more preferably made of a material containing copper at a certain ratio or more (for example, 90% by mass or more). The material (metal) constituting the metal pillar 11 and the electrode pad 21 may be the same or different.

The copper paste for joining 30 forms a joining portion between the metal pillar 11 and the electrode pad 21. In FIG. 1, the copper paste for joining 30 exists only between the metal pillar 11 and the electrode pad 21, but the disposition location of the copper paste for joining 30 is not limited thereto. That is, the copper paste for joining 30 may exist between at least the metal pillar 11 and the electrode pad 21, or may exist in a region other than the region between the metal pillar 11 and the electrode pad 21.

The thickness of the copper paste for joining in the laminate 50 (the distance from the joining surface of the metal pillar 11 to the joining surface of the electrode pad 21) may be 1 to 1000 μm, 5 to 500 μm, 10 to 500 μm, 15 to 500 μm, 20 to 300 μm, 50 to 200 μm, 10 to 3000 μm, 10 to 250 μm, or 15 to 150 μm. The thickness of the copper paste for joining may be 1 μm or more, 5 μm or more, 10 μm or more, 15 μm or more, 20 μm or more, or 50 μm or more. The thickness of the copper paste for joining may be 3000 μm or less, 1000 μm or less, 500 μm or less, 300 μm or less, 250 μm or less, 200 μm or less, or 150 μm or less.

The laminate 50 can be obtained, for example, by disposing the copper paste for joining 30 on at least one joining surface of the metal pillar 11 in the first member 10 and the electrode pad 21 in the second member 20 and then connecting the metal pillar 11 of the first member 10 and the electrode pad 21 of the second member 20 through the copper paste for joining 30. For example, as illustrated in FIG. 2, the laminate 50 may be obtained by disposing the copper paste for joining 30 on the joining surface of the electrode pad 21 in the second member 20 (see FIG. 2(a)), then disposing the first member 10 on the second member 20 such that the metal pillar 11 and the electrode pad 21 face each other through the copper paste for joining 30 (see FIG. 2(b)), and connecting the metal pillar 11 and the electrode pad 21 through the copper paste for joining 30 (see FIG. 2(c)). As illustrated in FIG. 3, the laminate 50 may be obtained by disposing the copper paste for joining 30 on the joining surface of the metal pillar 11 in the first member 10 (see FIG. 3(a)), then disposing the second member 20 on the first member 10 such that the metal pillar 11 and the electrode pad 21 face each other through the copper paste for joining 30 (see FIG. 3(b)), and connecting the metal pillar 11 and the electrode pad 21 (see FIG. 3(c)). The copper paste for joining 30 may be disposed on at least a part of the joining surface of the metal pillar 11 and the electrode pad 21, or may be disposed on the entire joining surface.

The method of disposing the copper paste for joining 30 on the joining surface of the metal pillar 11 and the electrode pad 21 may be a method capable of attaching the copper paste for joining to the joining surface (end surface) of the metal pillar 11 and the joining surface of the electrode pad 21, and a known method can be employed.

Specific examples of the method of attaching the copper paste for joining to the joining surface of the metal pillar 11 include a method of dipping the joining surface of the metal pillar 11 on the copper paste for joining thinly and uniformly stretched with a squeegee or the like, a method of transferring the copper paste for joining to the joining surface of the metal pillar 11 by a roller onto which the copper paste for joining is thinly and uniformly applied, and a method of printing the copper paste for joining on the joining surface of the metal pillar 11 by a needle dispenser.

Specific examples of the method of attaching the copper paste for joining to the joining surface of the electrode pad 21 include a method by printing such as screen printing, transfer printing, offset printing, anastatic printing, intaglio printing, gravure printing, stencil printing, or jet printing, a method using a dispenser (for example, a jet dispenser or a needle dispenser), a comma coater, a slit coater, a die coater, a gravure coater, a slit coater, a bar coater, an applicator, a spray coater, a spin coater, a dip coater, or the like, a method by soft lithography, a particle deposition method, and a method by electrodeposition coating.

Examples of the method of laminating the first member (for example, a microdevice) and the second member (for example, a substrate) include methods using a chip mounter, a flip-chip bonder, a carbon or ceramic positioning jig, and the like.

The copper paste for joining 30 disposed between the first member and the second member (between the metal pillar 11 and the electrode pad 21) may be dried from the viewpoint of suppressing the flow and occurrence of voids during sintering. That is, the manufacturing method of the present embodiment may further include a drying step of drying the copper paste for joining 30 after the first step and before the second step.

Drying may be performed in air, in an oxygen-free atmosphere of nitrogen, rare gas, or the like, or in a reducing atmosphere of hydrogen, formic acid, or the like. In a drying method, drying may be performed after being left to stand at normal temperature (for example, 25°C), heating drying may be performed, or drying under reduced pressure may be performed. In drying by heating or drying under reduced pressure, for example, a hot plate, a hot wind drier, a hot wind heating furnace, a nitrogen drier, an infrared drier, an infrared heating furnace, a far infrared heating furnace, a microwave heating apparatus, a laser heating apparatus, an electromagnetic heating apparatus, a heater heating apparatus, a vapor heating furnace, a hot-plate press apparatus, and the like can be used. Drying conditions (drying temperature and drying time) may be appropriately set according to the type and amount of the volatile component used in the copper paste for joining (for example, components other than metal particles, such as a dispersion medium). The drying conditions (drying temperature and drying time) may be, for example, conditions of drying at 50°C or higher and lower than 150°C for 1 to 120 minutes.

(Second step)

In the second step, the laminate 50 is heated under a gas atmosphere having a hydrogen concentration of 4.5% or less to sinter the copper paste for joining 30 at a predetermined sintering temperature, thereby obtaining a sintered body 31. Thereby, a joined body 100, which includes the first member 10, the second member 20, and the sintered body (joining portion) 31 provided between the metal pillar 11 and the electrode pad 21, is obtained (see FIG. 1(b)). In the joined body 100, the metal pillar 11 and the electrode pad 21 are electrically connected by the sintered body 31.

In heating treatment, for example, a hot plate, a hot wind drier, a hot wind heating furnace, a nitrogen drier, an infrared drier, an infrared heating furnace, a far infrared heating furnace, a microwave heating apparatus, a laser heating apparatus, an electromagnetic heating apparatus, a heater heating apparatus, a vapor heating furnace, and the like can be used.

The sintering temperature (the highest temperature reached during the heating treatment) may be 150 to 300°C, 170 to 250°C, or 200 to 250°C, from the viewpoint of sufficiently performing sintering, the viewpoint of reducing thermal damage to the first member (for example, a microdevice) and the second member (for example, a substrate), and the viewpoint of improving a yield ratio. The sintering temperature may be 150°C or higher, 170°C or higher, or 200°C or higher. The sintering temperature may be 300°C or lower or 250°C or lower. When the sintering temperature is 300°C or lower, sintering can be sufficiently performed with less thermal damage to the first member and the second member and a sufficient joining strength tends to be obtainable. When the sintering temperature is 150°C or higher, even in the case of the sintering time of 60 minutes or shorter, sintering tends to be sufficiently performed. Even when the sintering temperature is lower than 150°C, by setting the sintering time to longer than 60 minutes, sintering can be sufficiently performed. In order to improve reliability in reliability tests such as a temperature cycle test and a power cycle test, the heating treatment can also be performed under the condition of 300°C or higher.

The sintering time (retention time at the highest temperature reached) may be 1 minute or longer, 1.5 minutes or longer, or 2 minutes or longer from the viewpoints that volatile components (for example, components other than the metal particles, such as a dispersion medium) are sufficiently removed and sintering can be sufficiently performed. The sintering time may be 60 minutes or shorter, shorter than 40 minutes, or shorter than 30 minutes from the viewpoint of improving a yield ratio. From these viewpoints, the sintering time may be 1 to 60 minutes, 1 minute or longer and shorter than 40 minutes, or 1 minute or longer and shorter than 30 minutes. In particular, when the sintering temperature is 150 to 300°C, the sintering time is preferably within the above range.

The atmosphere in which the laminate 50 is heated in the second step is a gas atmosphere having a hydrogen concentration of 4.5% or less, and taking into consideration of explosiveness of hydrogen gas, may be a gas atmosphere not containing hydrogen.

Examples of the gas atmosphere include a mixed gas atmosphere containing hydrogen and rare gas and/or nitrogen, a gas atmosphere containing formic acid gas, a mixed gas atmosphere containing formic acid gas and rare gas and/or nitrogen, and a gas atmosphere containing rare gas and/or nitrogen. As the gas atmosphere not containing hydrogen, from the viewpoint of an inert gas, a nitrogen gas atmosphere, an argon gas atmosphere, or a mixed gas atmosphere of nitrogen gas and argon gas are preferred.

The second step is performed under non-pressuritzaion, a state in which the copper paste for joining receives only the weight of a member to be joined or receives a micropressure of 0.01 MPa or less in addition to the weight thereof, in other words, a pressure is 0.01 MPa or less. Examples of a method in which the copper paste for joining receives a pressure of 0.01 MPa or less include a method in which a weight is placed on the member (for example, the first member) disposed on the upper side in the vertical direction and a method of applying a pressure with a spring jig.

As described above, in the method for manufacturing a joined body of the present invention, by using the copper paste for joining of the present invention, it is possible to obtain a sufficient joining strength even in the case of heating the copper paste for joining under a gas atmosphere not containing hydrogen or a gas atmosphere having a low hydrogen concentration. Further, even under non-pressurization, a sufficient joining strength can be obtained. Since the method for manufacturing a joined body of the present invention can also be executed in a joining apparatus that is not explosion-proof and a sufficient joining strength can be obtained even under non-pressurization, effects such as simplification of a process, simplification of a joining apparatus, and improvement in a production yield ratio can be obtained.

The shear strength of the joined body 100 may be 5 MPa or more, may be 7 MPa or more, may be 10 MPa or more, or may be 15 MPa or more, from the viewpoint of sufficiently joining the first member and the second member. The die shear strength can be measured by using a universal bond tester (Royce 650, manufactured by Royce Instruments), a universal bond tester (4000 series, manufactured by Nordson Dage), or the like.

The method for manufacturing a joined body of the present embodiment can be applied to flip-chip joining of microdevices.

The method for manufacturing a joined body of the present embodiment is not limited to the above-described embodiment and can be variously modified.

For example, the first member and the second member may be wafers or chips including one or two or more semiconductors selected from the group consisting of silicon, gallium nitride, and silicon carbide, and the first electrode and the second electrode may be through electrodes. According to this method, it is possible to obtain, as the joined body, a semiconductor device which is a laminate of a plurality of semiconductor wafers and/or semiconductor chips provided with through electrodes and in which layers are microbump-joined.

Examples of the above-described wafer or chip include a silicon wafer, a gallium nitride wafer, a silicon carbide wafer, a silicon chip, a gallium nitride chip, and a silicon carbide chip. Furthermore, examples of the wafer or chip including two or more kinds of semiconductors include those in which gallium nitride is laminated on a silicon wafer or chip.

Further, the method for manufacturing a joined body of the present embodiment will be specifically described with reference to the drawings.

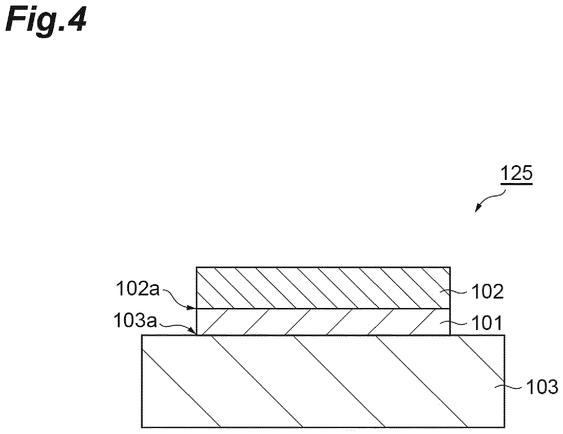

FIG. 4 is a schematic cross-sectional view illustrating an example of a joined body manufactured by the method for manufacturing a joined body of the present embodiment.

A joined body 125 illustrated in FIG. 4 includes a first member 102, a second member 103, and a sintered body 101 of the copper paste for joining of the present embodiment that joins the first member 102 and the second member 103.

Examples of the first member and the second member include semiconductor elements such as semiconductor wafers, semiconductor chips, IGBT, diodes, Schottky barrier diodes, MOS-FET, thyristors, logic circuits, sensors, analog integrated circuits (analog IC), power IC, LED, semiconductor lasers, and transmitters; lead frames; metal plate-attached ceramic substrates (for example, DBC); base materials for mounting a semiconductor element such as LED packages; metal wirings such as copper ribbons and metal frames; block bodies such as metal blocks; members for power supply such as terminals; heat dissipation plates; and water cooling plates.

Surfaces 102a and 103a of the first member 102 and the second member 103 in contact with the sintered body of the copper paste for joining may contain a metal. Examples of the metal include copper, nickel, silver, gold, palladium, platinum, lead, tin, and cobalt. The metal may be used alone or in combination of two or more kinds thereof. Furthermore, the surfaces in contact with the sintered body may be an alloy including the above-described metal. Examples of the metal used in the alloy include zinc, manganese, aluminum, beryllium, titanium, chromium, iron, and molybdenum, in addition to the above-described metal. Examples of a member in which the surfaces in contact with the sintered body contain a metal include members having various metal platings (such as chips having metal plating and lead frames having various metal platings), wires, heat spreaders, ceramic substrates to which a metal plate is attached, lead frames made of various metals, copper plates, and copper foils.

The shear strength of the joined body 125 may be 5 MPa or more, may be 7 MPa or more, may be 10 MPa or more, or may be 15 MPa or more, from the viewpoint of sufficiently joining the first member 102 and the second member 103. The die shear strength can be measured by using a universal bond tester (Royce 650, manufactured by Royce Instruments), a universal bond tester (4000 series, manufactured by Nordson Dage), or the like.

In the above-described joined body 125, in a case where the first member is a semiconductor element, the above-described joined body 125 is a semiconductor device.

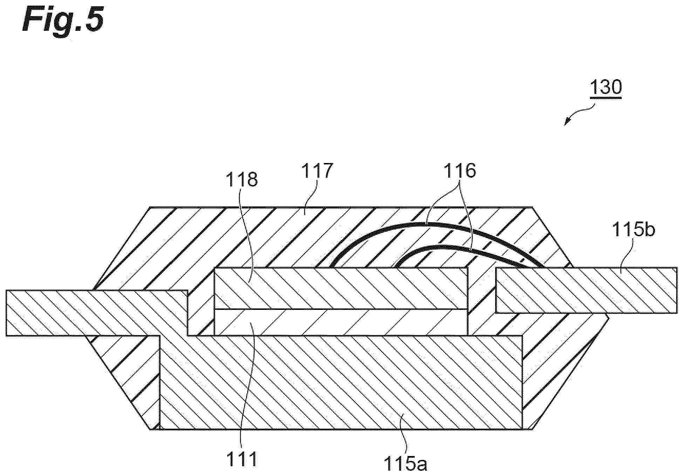

FIG. 5 is a schematic cross-sectional view illustrating an example of a semiconductor device manufactured by the method for manufacturing a joined body of the present embodiment. A semiconductor device 130 illustrated in FIG. 5 includes a sintered body 111 of the copper paste for joining according to the present embodiment, a lead frame 115a, a lead frame 115b, a wire 116, a semiconductor element 118 connected on the lead frame 115a through the sintered body 111, and a mold resin 117 molding these components. The semiconductor element 118 is connected to the lead frame 115b through a wire 116.

Examples of the semiconductor device include power modules such as a diode, a rectifier, a thyristor, a MOS gate driver, a power switch, a power MOSFET, IGBT, a Schottky diode, and a fast recovery diode; a transmitter; an amplifier; a high-brightness LED module; and a sensor.

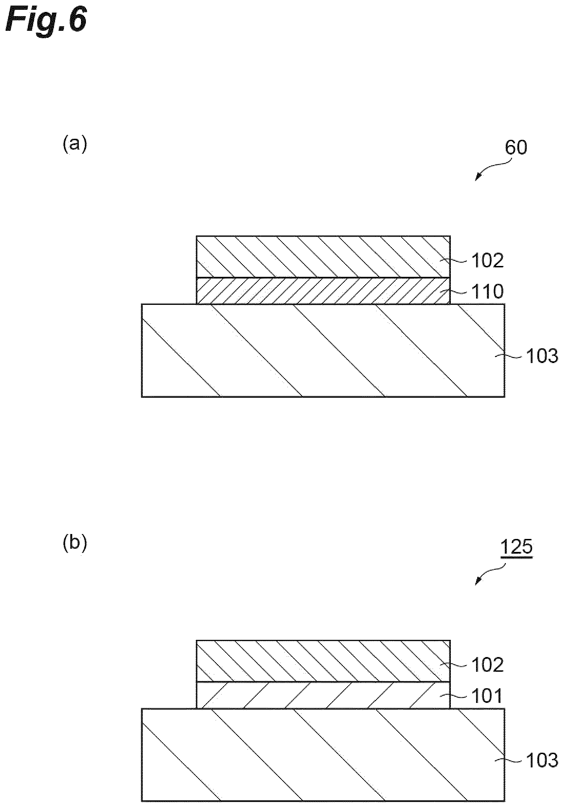

FIG. 6 (FIG. 6(a) and FIG. 6(b)) is a schematic cross-sectional view for describing a method for manufacturing the joined body 125. The method for manufacturing the joined body 125 according to the present invention includes a step of preparing a laminate 60 in which the first member 102, and the above-described copper paste for joining 110 and the second member 103, which are disposed in a direction in which the weight of the first member 102 applies, are laminated in this order (FIG. 6(a)) and heating the laminate 60 under a gas atmosphere having a hydrogen concentration of 4.5% or less to sinter the copper paste for joining 110. Thereby, the joined body 125 is obtained (FIG. 6(b)). Note that, the direction in which the weight of the first member 102 applies can also be a direction in which the gravitational force applies.

In the above-described step, the copper paste for joining 110 is sintered in a state of receiving a weight of the first member 102 or in a state of receiving a weight of the first member 102 and a micropressure of 0.01 MPa or less (in other words, under the condition of a pressure of 0.01 MPa or less).

The above-described laminate 60 can be prepared by the same method and conditions as those of the laminate 50 described above. Drying and sintering of the copper paste for joining 110 can also be performed by the same method and conditions as those of the copper paste for joining 30 described above.

The thickness of the copper paste for joining 110 may be 1 $\mu$m or more, 5 $\mu$m or more, 10 $\mu$m or more, 15 $\mu$m or more, 20 $\mu$m or more, or 50 $\mu$m or more, or may be 3000 $\mu$m or less, 1000 $\mu$m or less, 500 $\mu$m or less, 300 $\mu$m or less, 250 $\mu$m or less, or 150 $\mu$m or less. For example, the thickness of the copper paste for joining 10 may be 1 to 1000 $\mu$m, may be 10 to 500 $\mu$m, may be 50 to 200 $\mu$m, may be 10 to 3000 $\mu$m, may be 15 to 500 $\mu$m, may be 20 to 300 $\mu$m, may be 5 to 500 $\mu$m, may be 10 to 250 $\mu$m, or may be 15 to 150 $\mu$m.

Examples of the method of disposing one member on the other member (for example, the method of disposing the first member 102 on the second member 103 on which the copper paste for joining 110 is provided) include methods using a chip mounter, a flip-chip bonder, a carbon or ceramic positioning jig, and the like.

By using the copper paste for joining 110 of the present invention, even when heating is performed under a gas atmosphere having a hydrogen concentration of 4.5% or less, the joined body can have a sufficient joining strength. Furthermore, by performing joining under non-pressurization, the joined body can have a sufficient joining strength.

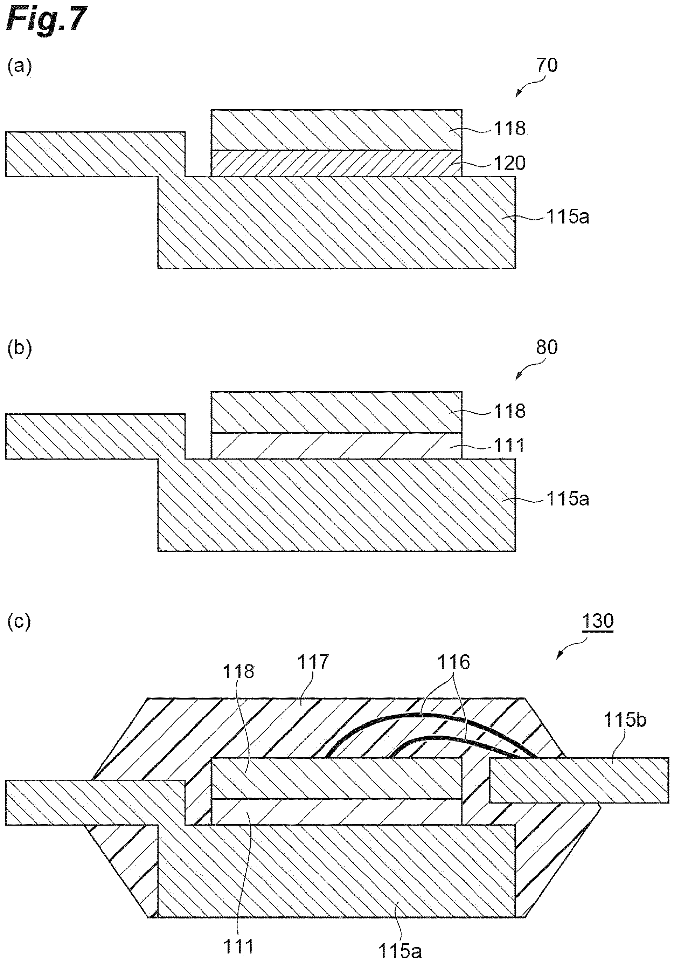

The semiconductor device 130 according to the present embodiment can be manufactured in the same manner as in the method for manufacturing the joined body 125 described above. That is, the method for manufacturing a semiconductor device includes a step of preparing a laminate in which the first member, and the above-described copper paste for joining and the second member, which are disposed in a direction in which the weight of the first member applies, are laminated in this order, using a semiconductor element for at least one of the first member and the second member, and heating the laminate under a gas atmosphere having a hydrogen concentration of 4.5% or less to sinter the copper paste for joining. For example, illustrated in FIG. 7 (FIG. 7(a) to FIG. 7(c)), a joined body 80 is obtained by providing a copper paste for joining 120 on the lead frame 115a and disposing the semiconductor element 118 to obtain a laminate 70 (FIG. 7(a)), then heating this laminate 70, and sintering the copper paste for joining 120 (FIG. 7(b)). Next, the lead frame 115b and the semiconductor element 118 in the obtained joined body 80 are connected by the wire 116 and these are sealed by a sealing resin. The semiconductor device 130 is obtained by the above step (FIG. 7(c)). The semiconductor device 120 to be obtained can have a sufficient die shear strength and connection reliability even in the case of performing joining under a gas atmosphere having a hydrogen concentration of 4.5% or less, under non-pressurization. Since the semiconductor device of the present embodiment includes a sintered body of the copper paste for joining having sufficient joining force and containing copper with a high thermal conductivity and a high melting point, the semiconductor device has a sufficient die shear strength, is excellent in connection reliability, and can also become excellent in power cycle resistance.

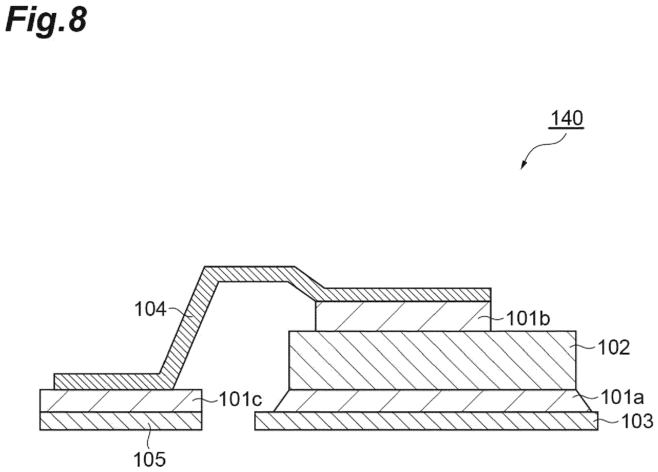

A joined body 140 illustrated in FIG. 8 includes the first member 102, the second member 103, a third member 104, a fourth member 105, a sintered body 101a of the above-described copper paste for joining that joins the first member 102 and the second member 103, a sintered body 101b of the above-described copper paste for joining that joins the first member 102 and the third member 104, a sintered body 101c of the above-described copper paste for joining that joins the third member 104 and the fourth member 105.

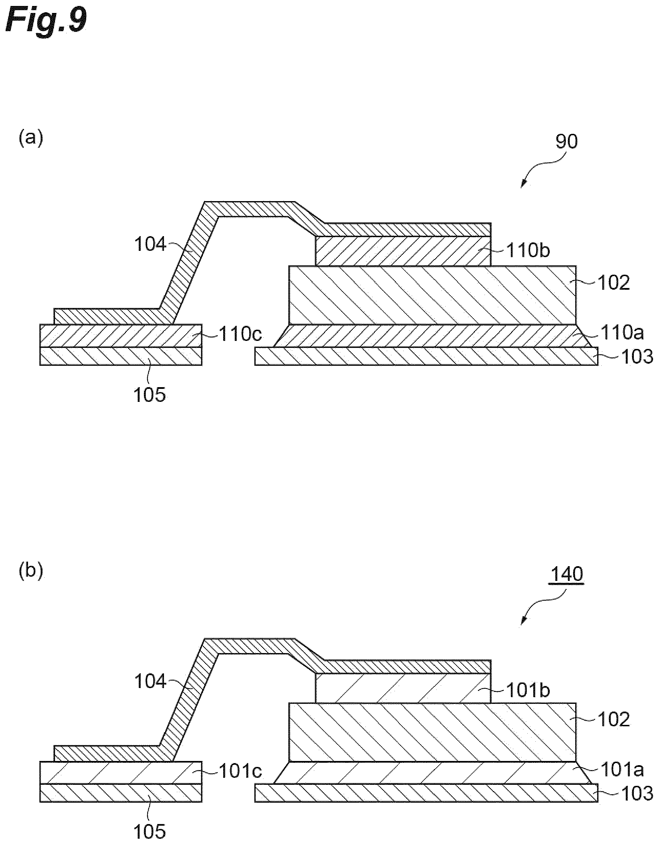

Such a joined body 140 can be obtained, for example, as illustrated in FIG. 9 (FIG. 9(a) and FIG. 9(b)), by a method including a step of preparing a laminate 90 which has a laminate portion in which the third member 104, and a second copper paste for joining 110b, the first member 102, a first copper paste for joining 110a, and the second member 103, which are disposed in a direction to which the weight of the third member 104 applies, are laminated in this order, and a laminate portion in which the third member 104, and a third copper paste for joining 110c and the fourth member 105, which are disposed in the direction to which the weight of the third member 104 applies, are laminated in this order (FIG. 9(a)), and sintering the first copper paste for joining 110a, the second copper paste for joining 110b, and the third copper paste for joining 110c in the same method as the method for manufacturing the joined body 125 described above (FIG. 9(b)). In the above-described method, the first copper paste for joining 1 10a, the second copper paste for joining 110b, and the third copper paste for joining 110c are the copper paste for joining according to the present embodiment, the first copper paste for joining 110a is sintered to obtain the sintered body 101a, the second copper paste for joining 110b is sintered to obtain the sintered body 101b, and the third copper paste for joining 110c is sintered to obtain the sintered body 101c.

Furthermore, the joined body 140 can also be obtained, for example, by a method including a step of forming a laminate portion in which the third member 104, and the second copper paste for joining 110b and the first member 102, which are disposed in a direction to which the weight of the third member 4 applies, are laminated in this order and a laminate portion in which the third member 104, and the third copper paste for joining 110c and the fourth member 105, which are disposed in the direction to which the weight of the third member 104 applies, are laminated in this order after obtaining the above-described joined body 125, and sintering the second copper paste for joining 110b and the third copper paste for joining 110c in the same method as the method for manufacturing the joined body 125 described above.

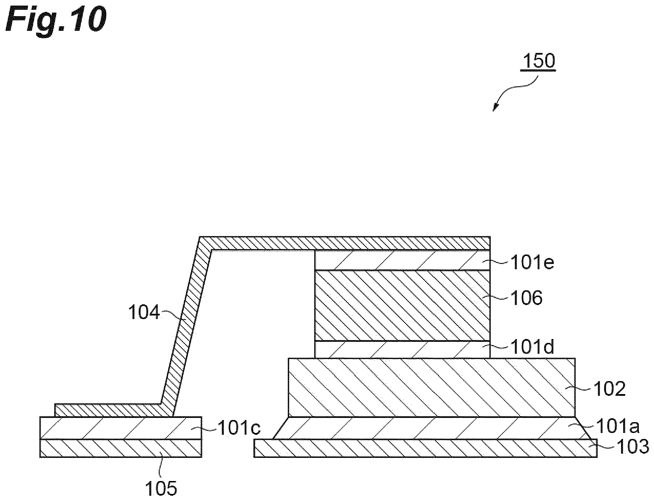

A joined body 150 illustrated in FIG. 10 includes the first member 102, the second member 103, the third member 104, the fourth member 105, a fifth member 106, the sintered body 101a of the above-described copper paste for joining that joins the first member 102 and the second member 103, the sintered body 101c of the above-described copper paste for joining that joins the third member 104 and the fourth member 105, a sintered body 101d of the above-described copper paste for joining that joins the first member 102 and the fifth member 106, and a sintered body 101e of the above-described copper paste for joining that joins the third member 104 and the fifth member 106.

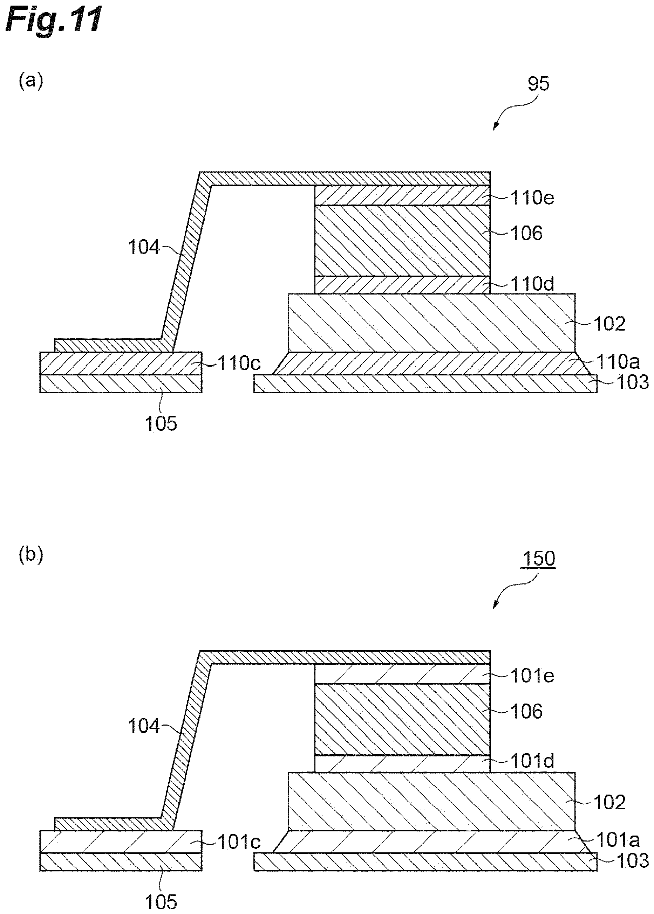

Such a joined body 150 can be obtained, for example, as illustrated in FIG. 11 (FIG. 11(a) and FIG. 11(b)), by a method including a step of preparing a laminate 95 which has a laminate portion in which the third member 104, and a fifth copper paste for joining 110e, the fifth member 106, a fourth copper paste for joining 110d, the first member 102, the first copper paste for joining 110a, and the second member 103, which are disposed in a direction to which the weight of the third member 104 applies, are laminated in this order, and a laminate portion in which the third member 104, and the third copper paste for joining 110c and the fourth member 105, which are disposed in the direction to which the weight of the third member 104 applies, are laminated in this order (FIG. 11(a)), and sintering the first copper paste for joining 110a, the third copper paste for joining 110c, the fourth copper paste for joining 1 10d, and the fifth copper paste for joining 110e in the same method as the method for manufacturing the joined body 125 described above (FIG. 11(b)). In the above-described method, the first copper paste for joining 110a, the third copper paste for joining 110c, the fourth copper paste for joining 110d, and the fifth copper paste for joining 110e are the copper paste for joining according to the present embodiment, the first copper paste for joining 110a is sintered to obtain the sintered body 101a, the third copper paste for joining 110c is sintered to obtain the sintered body 101c, the fourth copper paste for joining 110d is sintered to obtain the sintered body 101d, and the fifth copper paste for joining 110e is sintered to obtain the sintered body 101e.

Furthermore, the joined body 150 can also be obtained by a method including a step of preparing a laminate in which the third member 104, and the fifth copper paste for joining 110e, the fifth member 106, the fourth copper paste for joining 110d, the first member 102, the first copper paste for joining 110a, and the second member 103, which are disposed in a direction to which the weight of the third member 104 applies, are laminated in this order, sintering the first copper paste for joining 110a, the fourth copper paste for joining 110d, and the fifth copper paste for joining 110e in the same method as the method for manufacturing the joined body 125 described above, then forming a laminate portion in which the third member 104, and the third copper paste for joining 110c and the fourth member 105, which are disposed in the direction to which the weight of the third member 104 applies, are laminated in this order, and sintering the third copper paste for joining 110c in the same method as the method for manufacturing the joined body 125 described above.

Furthermore, the joined body 150 can also be obtained by a method including a step of forming a laminate portion in which the third member 104, and the fifth copper paste for joining 110e, the fifth member 106, the fourth copper paste for joining 110d, and the first member 102, which are disposed in a direction to which the weight of the third member 104 applies, are laminated in this order, and a laminate portion in which the third member 104, and the third copper paste for joining 110c and the fourth member 105, which are disposed in the direction to which the weight of the third member 104 applies, are laminated in this order after obtaining the above-described joined body 125, and sintering the third copper paste for joining 110c, the fourth copper paste for joining 110d, and the fifth copper paste for joining 110e in the same method as the method for manufacturing the joined body 125 described above.

In the above-described modified examples, examples of the third member 104, the fourth member 105, and the fifth member 106 are the same as examples of the second member 103, and for example, the third member 104 may be a metal wiring such as a copper ribbon and a metal frame, the fourth member 105 may be a terminal or a lead frame, and the fifth member 106 may be a block body such as a metal block. Furthermore, surfaces of the third member 104, the fourth member 105, and the fifth member 106 in contact with the sintered body of the copper paste for joining may contain a metal. Examples of metals which may be contained are the same as examples of metals which may be contained in the surfaces of the first member 102 and the second member 103 in contact with the sintered body of the copper paste for joining. Furthermore, the first copper paste for joining 110a, the second copper paste for joining 110b, the third copper paste for joining 110c, the fourth copper paste for joining 110d, and the fifth copper paste for joining 110e which are used in the above-described modified examples may be the same as or different from each other.

<Joined body>

A joined body obtained by using the copper paste for joining of the present embodiment includes a first member, a second member, and a sintered body of the copper paste for joining of the present embodiment that joins the first member and the second member. The joined body can be obtained by the method for manufacturing a joined body of the present invention described above.

At least one of the first member and the second member may be a semiconductor element. That is, the joined body may be a semiconductor device.

In the joined body, the first member may have a first electrode, the second member may have a second electrode facing the first electrode, and the sintered body may join the first electrode and the second electrode.

At least one of the first electrode and the second electrode may be a metal pillar.

The first member and the second member may be wafers or chips including one or two or more semiconductors selected from the group consisting of silicon, gallium nitride, and silicon carbide, and the first electrode and the second electrode may be through electrodes provided in a semiconductor wafer and/or a semiconductor chip. This joined body can be applied to LSI having a structure in which connection is performed using TSV (Through Silicon Via).

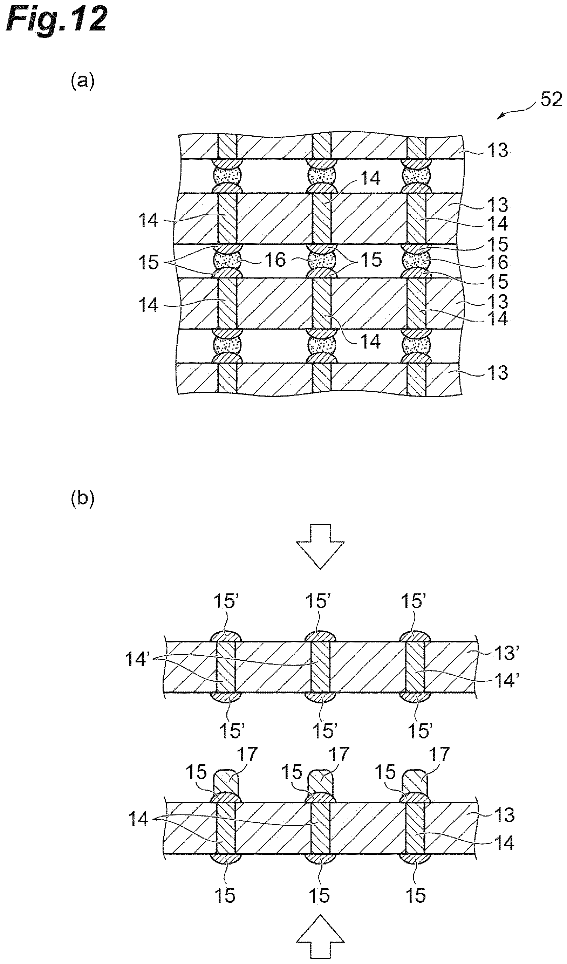

FIG. 12 is a schematic cross-sectional view for describing a joined body in which TSV chip layers are microbump-joined and a manufacturing method therefor. A joined body 52 illustrated in FIG. 12(a) has a structure in which a plurality of semiconductor chips 13 provided with through electrodes 14 are joined through microbumps 15 and sintered bodies 16. The sintered body 16 is a sintered body of the copper paste for joining of the present embodiment.

The joined body 52 can be manufactured in the same manner as in the method for manufacturing the joined body described above. For example, as illustrated in FIG. 12(b), a joined body can be obtained by disposing a copper paste for joining 17 on the microbump 15 in one semiconductor chip 13, then disposing the other semiconductor chip 13' on the one semiconductor chip 13 such that the microbump 15 and a microbump 15' in the other semiconductor chip 13' face each other through the copper paste for joining 17, and connecting the microbump 15 and the microbump 15' through the sintered copper paste for joining 17. This step is performed repeatedly or simultaneously, and thereby the joined body 52 is obtained.

**Examples**

Hereinafter, the present invention will be described more specifically by way of Examples and Comparative Example; however, the present invention is not intended to be limited to the following Examples.

<Preparation of copper paste for joining>

(Example 1)

6.16 g of CH-0200 (manufactured by MITSUI MINING & SMELTING CO., LTD., product name, 50% volume average particle diameter: 0.36 $\mu$m, manufactured by MITSUI MINING & SMELTING CO., LTD.) as material containing submicro copper particles, 1.1956 g of dihydroterpineol (manufactured by Nippon Terpene Chemicals, Inc.), and 0.0044 g of 2,2-dimethylglutaric acid (melting point: 83°C, manufactured by FUJIFILM Wako Pure Chemical Corporation) were mixed by a stirrer manufactured by THINKY CORPORATION (trade name: "Awatori Rentaro ARE-310", hereinafter, the same applies) under the condition of 2000 rpm and for 1 minute. Thereafter, the dispersion treatment was performed 10 times with a three-roll mill to obtain a mixture.

The mixture obtained by the dispersion treatment was transferred to a polyethylene container, and then 2.64 g of 1050YF (manufactured by MITSUI MINING & SMELTING CO., LTD., product name, 50% volume average particle diameter: 1.7 $\mu$m, aspect ratio: 7) was weighed as a material containing flake-shaped micro copper particles and added to the container, and mixed by a stirrer manufactured by THINKY CORPORATION under the condition of 2000 rpm and for 1 minute. Thereafter, the dispersion treatment was performed 5 times with a three-roll mill to obtain a copper paste for joining.

(Examples 2 to 11 and Comparative Example 1)

Copper pastes for j oining were prepared in the same manner as in Example 1, except that the composition of the copper paste for joining was changed to the composition shown in Table 1 or Table 2 (the unit of the numerical value is g).

<Evaluation of copper paste for joining>

The joining strength and the storage stability of the copper pastes for joining obtained above were evaluated according to the following method. Results are shown in Table 1 and Table 2.

(Joining strength)

The joining strength was evaluated using a shear strength. First, the copper paste for joining was stencil printed to an oxygen-free copper plate (19 mm × 25 mm × thickness 3 mm) by using a stencil mask having a thickness of 100 $\mu$m and heated under each condition described below, thereby producing each of samples for measurement in which ten bumps having a bump diameter of 200 $\mu$m are formed on the copper plate.

Heating condition 1: gas atmosphere having a hydrogen concentration of 4.5% and a nitrogen concentration of 95.5%, heating temperature: 30°C, heating time: 60 minutes

Heating condition 2: gas atmosphere having a hydrogen concentration of 10% and a nitrogen concentration of 90%, heating temperature: 30°C, heating time: 60 minutes

Heating condition 3: gas atmosphere having a nitrogen concentration of 100%, heating temperature: 30°C, heating time: 60 minutes

A shear test was performed by pressing the bumps of the sample for measurement obtained above in a horizontal direction by using a universal bond tester Dage4000 (manufactured by Nordson Advanced Technology, product name) mounted with a load cell (BS-5KG, manufactured by Nordson Advanced Technology) under conditions of a temperature of 25°C, a shear speed of 100 $\mu$m/sec, and a shear height of 10 $\mu$m. Next, the fracture cross-section part of the bump after the test was observed by a digital microscope VHX-5000 (manufactured by KEYENCE CORPORATION, product name) and the total area of the fracture cross-section was calculated. The joining strength was evaluated from the shear strength per unit area obtained by dividing the obtained shear strength by the total area on the basis of the following criteria for determination.

[Criteria for determination]

A: The shear strength is 15 MPa or more.

B: The shear strength is 10 MPa or more and less than 15 MPa.

C: The shear strength is 5 MPa or more and less than 10 MPa.

D: The shear strength is less than 5 MPa.

(Storage stability)

The copper paste for joining was stored in an environment of -30°C for 168 hours. The copper paste for joining after storage was stencil printed on the copper plater by using a stencil mask having a cylindrical opening portion with an opening diameter of 200 $\mu$m and having a thickness of 100 $\mu$m. The storage stability was evaluated from printing properties at this time on the basis of the following criteria for determination.

[Criteria for determination]

A: Printing can be performed without missing the paste.

B: The paste is missed.

C: Printing cannot be performed.

[Table 1]

| | | | Example 1 | Example 2 | Example 3 | Example 4 | Example 5 | Example 6 |
|---|---|---|---|---|---|---|---|---|
| Paste composition | Copper particles | Submicro copper particles A | 6.16 | 6.16 | 6.16 | 6.16 | 6.37 | 5.95 |
| | | Micro copper particles B | 2.64 | 2.64 | 2.64 | 2.64 | 2.73 | 2.55 |
| | | Micro copper particles C | - | - | - | - | - | - |
| | Dispersion medium | Dihydroxyterpineol | 1.1956 | 1.1912 | 1.068 | 1.1824 | 0.8909 | 1.4915 |
| | Additive | 2,2-Dimethylglutaric acid | 0.0044 | 0.0088 | 0.132 | 0.0176 | 0.0091 | 0.0085 |
| | | 3,3-Dimethylglutaric acid | - | - | - | - | - | - |
| | | 2,4-Dimethylglutaric acid | - | - | - | - | - | - |
| Evaluation | Shear strength | Hydrogen concentration 4.5% | B | B | A | A | B | B |
| | | Hydrogen concentration 10% | B | A | A | A | A | A |
| | | Nitrogen concentration 100% | C | B | B | B | B | B |
| | Storage stability | | A | A | B | B | A | A |

[Table 2]

| | | | Example 7 | Example 8 | Example 9 | Example 10 | Example 11 | Comparative Example 1 |
|---|---|---|---|---|---|---|---|---|
| Paste composition | Copper particles | Submicro copper particles A | 6.16 | 6.16 | 6.16 | 6.16 | 6.16 | 6.16 |
| | | Micro copper particles B | 2.64 | 2.64 | - | - | - | - |
| | | Micro copper particles C | - | - | 2.64 | 2.64 | 2.64 | 2.64 |
| | Dispersion medium | Dihydroxyterpineol | 1.1912 | 1.1912 | 1.1912 | 1.1912 | 1.1912 | 1.2 |
| | Additive | 2,2-Dimethylglutaric acid | - | - | 0.0088 | - | - | - |
| | | 3,3-Dimethylglutaric acid | 0.0088 | - | - | 0.0088 | - | - |
| | | 2,4-Dimethylglutaric acid | - | 0.0088 | - | - | 0.0088 | - |
| Evaluation | Shear strength | Hydrogen concentration 4.5% | B | B | B | B | B | C |
| | | Hydrogen concentration 10% | A | A | A | A | A | B |
| | | Nitrogen concentration 100% | B | B | B | B | B | D |
| | Storage stability | | A | A | A | A | A | A |

EP 4 023 363 B1

The details of Submicro copper particles A, Micro copper particles B, and Micro copper particles C in the tables are as described below.

Submicro copper particles A: CH-0200 (manufactured by MITSUI MINING & SMELTING CO., LTD., product name, 50% volume average particle diameter: 0.36 $\mu$m, manufactured by MITSUI MINING & SMELTING CO., LTD.)

Micro copper particles B: 1050YF (manufactured by MITSUI MINING & SMELTING CO., LTD., product name, 50% volume average particle diameter: 1.7 $\mu$m, aspect ratio 7)

Micro copper particles C: 2L3N (manufactured by Fukuda Metal Foil & Powder Co., Ltd., product name, 50% volume average particle diameter: 7.2 $\mu$m, aspect ratio 5.2)

## Reference Signs List

10: first member, 11: metal pillar, 12: first substrate, 20: second member, 21: electrode pad, 22: second substrate, 30: copper paste for joining, 31: sintered body, 50, 60, 70, 90, 95: laminate, 80, 100: joined body, 101, 1a, 1b, 1c, 1d, 1e, 11: sintered body of copper paste for joining, 102: first member, 103: second member, 110, 110a, 110b, 110c, 110d, 110e, 120: copper paste for joining, 115a, 115b: lead frame, 116: wire, 117: mold resin, 118: semiconductor element, 125, 140, 150: joined body, 130: semiconductor device.

## Claims

1. A copper paste for joining (30, 110, 110a, 110b, 110c, 110d, 110e, 120), comprising: copper particles; a dimethylglutaric acid; and a dispersion medium,

   wherein a content of the dimethylglutaric acid is 0.05 to 1.5% by mass on the basis of the total amount of the copper particles, and
   wherein the copper paste for joining (30, 110, 110a, 110b, 110c, 110d, 110e, 120) contains submicro copper particles having a volume average particle diameter of 0.12 to 0.8 $\mu$m and flake-shaped micro copper particles having a maximum diameter of 2 to 50 $\mu$m and an aspect ratio of 3.0 or more as the copper particles, and
   wherein the copper paste for joining (30, 110, 110a, 110b, 110c, 110d, 110e, 120) contains dihydroterpineol as the dispersion medium, and
   wherein a content of the submicro copper particles is 30 to 90% by mass on the basis of the total mass of the copper particles, and
   a content of the micro copper particles is 10 to 70% by mass on the basis of the total mass of the copper particles, and
   wherein a content of the dispersion medium is 5 to 20% by mass on the basis of the total mass of the copper paste for joining, and
   wherein a content of the dihydroterpineol is 60% by mass or more on the basis of the total mass of the dispersion medium, and
   wherein the copper paste for joining (30, 110, 110a, 110b, 110c, 110d, 110e, 120) is for non-pressurization joining;
   wherein the volume average particle diameter means a 50% volume average particle diameter and is measured by the following method: first, metal particles serving as a raw material or dried metal particles obtained by removing a volatile component from the metal paste are dispersed in a dispersion medium by using a dispersant; next, the volume average particle diameter of the obtained dispersion element is measured by a light scattering-method particle size distribution analyzer;
   and wherein the maximum diameter of the flake-shaped micro copper particles is obtained from SEM images of the particles; the maximum diameter of the flake-shaped micro copper particles being obtained as a major axis X of the major axis of the flake-shaped micro copper particles; the major axis X being a distance of two parallel planes that are selected so that the distance between two parallel planes is the largest among two parallel planes circumscribing the flake-shaped micro copper particles in the three-dimensional shape of the flake-shaped micro copper particles.

2. The copper paste for joining (30, 110, 110a, 110b, 110c, 110d, 110e, 120) according to claim 1, wherein the content of the dihydroterpineol is 100% by mass on the basis of the total mass of the dispersion medium.

3. A method for manufacturing a joined body (80, 100, 125, 140, 150), the method comprising:

a first step of preparing a laminate (50, 60, 70, 90, 95) in which a first member (10, 102), the copper paste for joining (30, 110, 110a, 110b, 110c, 110d, 110e, 120) according to claim 1 or 2, and a second member (20, 103) are laminated in this order; and

a second step of heating the laminate (50, 60, 70, 90, 95) under a gas atmosphere having a hydrogen concentration of 4.5% or less to sinter the copper paste for joining (30, 110, 110a, 110b, 110c, 110d, 110e, 120), wherein in the second step, the copper paste for joining (30, 110, 110a, 110b, 110c, 110d, 110e, 120) is heated and sintered in a state of receiving a weight of the first member (10, 102) or in a state of receiving a weight of the first member (10, 102) and a micropressure of 0.01 MPa or less.

4. The method for manufacturing a joined body (80, 100, 125, 140, 150) according to claim 3, wherein the gas atmosphere is a nitrogen gas atmosphere.

5. The method for manufacturing a joined body (80, 100, 125, 140, 150) according to claim 3 or 4, wherein at least one of the first member (10, 102) and the second member (20, 103) is a semiconductor element (118).

6. The method for manufacturing a joined body (80, 100, 125, 140, 150) according to any one of claims 3 to 5, wherein in the laminate (50, 60, 70, 90, 95), the first member (10, 102) has a first electrode, the second member (20, 103) has a second electrode facing the first electrode, and the copper paste for joining (30, 110, 110a, 110b, 110c, 110d, 110e, 120) is provided between the first electrode and the second electrode.

7. The method for manufacturing a joined body (80, 100, 125, 140, 150) according to claim 6, wherein at least one of the first electrode and the second electrode is a metal pillar (11).

8. The method for manufacturing a joined body (80, 100, 125, 140, 150) according to claim 6, wherein the first member (10, 102) and the second member (20, 103) are chips including one or two or more semiconductors selected from the group consisting of silicon, gallium nitride, and silicon carbide, and the first electrode and the second electrode are through electrodes.

## Patentansprüche

1. Kupferpaste zum Verbinden (30, 110, 110a, 110b, 110c, 110d, 110e, 120), umfassend: Kupferteilchen; eine Dimethylglutarsäure; und ein Dispersionsmedium,

wobei der Gehalt an Dimethylglutarsäure 0,05 bis 1,5 Massenprozent, bezogen auf die Gesamtmenge der Kupferteilchen, beträgt, und

wobei die Kupferpaste zum Verbinden (30, 110, 110a, 110b, 110c, 110d, 110e, 120) Submikro-Kupferteilchen mit einem volumengemittelten Teilchendurchmesser von 0,12 bis 0,8 $\mu$m und schuppenförmige Mikro-Kupferteilchen mit einem maximalen Durchmesser von 2 bis 50 $\mu$m und einem Seitenverhältnis von 3,0 oder mehr als Kupferteilchen enthält, und

wobei die Kupferpaste zum Verbinden (30, 110, 110a, 110b, 110c, 110d, 110e, 120) Dihydroterpineol als Dispersionsmittel enthält, und

wobei der Gehalt der Submikro-Kupferteilchen 30 bis 90 Massenprozent auf der Basis der Gesamtmasse der Kupferteilchen beträgt, und

der Gehalt an Mikro-Kupferteilchen 10 bis 70 Massenprozent, bezogen auf die Gesamtmasse der Kupferteilchen, beträgt und

wobei der Gehalt des Dispersionsmediums 5 bis 20 Massenprozent, bezogen auf die Gesamtmasse der zu Kupferpaste zum Verbinden, beträgt, und

wobei der Gehalt an Dihydroterpineol 60 Massenprozent oder mehr, bezogen auf die Gesamtmasse des Dispersionsmediums, beträgt, und

wobei die Kupferpaste zum Verbinden (30, 110, 110a, 110b, 110c, 110d, 110e, 120) für eine drucklose Verbindung vorgesehen ist;

wobei der volumengemittelte Teilchendurchmesser einen 50% volumengemittelten Teilchendurchmesser bedeutet und durch das folgende Verfahren gemessen wird: zuerst werden Metallteilchen, die als Rohmaterial dienen, oder getrocknete Metallteilchen, die durch Entfernen einer flüchtigen Komponente aus der Metallpaste erhalten wurden, in einem Dispersionsmedium unter Verwendung eines Dispersionsmittels dispergiert; als nächstes wird der volumengemittelte Teilchendurchmesser des erhaltenen Dispersionselements durch einen Teilchengrößenverteilungsanalysator nach der Lichtstreuungsmethode gemessen;

und wobei der maximale Durchmesser der schuppenförmigen Mikro-Kupferteilchen aus SEM-Bildern der Teilchen erhalten wird; wobei der maximale Durchmesser der schuppenförmigen Mikro-Kupferteilchen als eine Hauptachse X der Hauptachse der schuppenförmigen Mikro-Kupferteilchen erhalten wird; wobei die Hauptachse X ein Abstand zweier paralleler Ebenen ist, die so gewählt sind, dass der Abstand zwischen zwei parallelen Ebenen der größte unter zwei parallelen Ebenen ist, die die schuppenförmigen Mikro-Kupferteilchen in der dreidimensionalen Form der schuppenförmigen Mikro-Kupferteilchen umschreiben.

2. Kupferpaste zum Verbinden (30, 110, 110a, 110b, 110c, 110d, 110e, 120) nach Anspruch 1, wobei der Gehalt an Dihydroterpineol 100 Massenprozent, bezogen auf die Gesamtmasse des Dispersionsmittels, beträgt.

3. Verfahren zur Herstellung eines gefügten Körpers (80, 100, 125, 140, 150), wobei das Verfahren umfasst:

einen ersten Schritt der Herstellung eines Laminats (50, 60, 70, 90, 95), in dem ein erstes Element (10, 102), die Kupferpaste zum Verbinden (30, 110, 110a, 110b, 110c, 110d, 110e, 120) gemäß Anspruch 1 oder 2 und ein zweites Element (20, 103) in dieser Reihenfolge laminiert sind; und
einen zweiten Schritt des Erhitzens des Laminats (50, 60, 70, 90, 95) unter einer Gasatmosphäre mit einer Wasserstoffkonzentration von 4,5% oder weniger, um die Kupferpaste zum Verbinden (30, 110, 110a, 110b, 110c, 110d, 110e, 120) zu sintern,
wobei im zweiten Schritt die Kupferpaste zum Verbinden (30, 110, 110a, 110b, 110c, 110d, 110e, 120) in einem Zustand, in dem sie ein Gewicht des ersten Elements (10, 102) aufnimmt, oder in einem Zustand, in dem sie ein Gewicht des ersten Elements (10, 102) und einen Mikrodruck von 0,01 MPa oder weniger aufnimmt, erhitzt und gesintert wird.

4. Verfahren zur Herstellung eines gefügten Körpers (80, 100, 125, 140, 150) nach Anspruch 3, wobei die Gasatmosphäre eine Stickstoffgasatmosphäre ist.

5. Verfahren zur Herstellung eines gefügten Körpers (80, 100, 125, 140, 150) nach Anspruch 3 oder 4, bei dem mindestens eines von dem ersten Element (10, 102) und dem zweiten Element (20, 103) ein Halbleiterelement (118) ist.

6. Verfahren zur Herstellung eines gefügten Körpers (80, 100, 125, 140, 150) nach einem der Ansprüche 3 bis 5, wobei in dem Laminat (50, 60, 70, 90, 95) das erste Element (10, 102) eine erste Elektrode aufweist, das zweite Element (20, 103) eine zweite Elektrode aufweist, die der ersten Elektrode zugewandt ist, und die Kupferpaste zum Verbinden (30, 110, 110a, 110b, 110c, 110d, 110e, 120) zwischen der ersten Elektrode und der zweiten Elektrode angeordnet ist.

7. Verfahren zur Herstellung eines gefügten Körpers (80, 100, 125, 140, 150) nach Anspruch 6, wobei mindestens eine der ersten Elektrode und der zweiten Elektrode ein Metallpfeiler (11) ist.

8. Verfahren zur Herstellung eines gefügten Körpers (80, 100, 125, 140, 150) nach Anspruch 6, wobei das erste Element (10, 102) und das zweite Element (20, 103) Chips sind, die einen oder zwei oder mehr Halbleiter enthalten, die aus der Gruppe ausgewählt sind, die aus Silizium, Galliumnitrid und Siliziumkarbid besteht, und die erste Elektrode und die zweite Elektrode Durchgangselektroden sind.

**Revendications**

1. Pâte de cuivre pour l'assemblage (30, 110, 110a, 110b, 110c, 110d, 110e, 120), comprenant : des particules de cuivre ; un acide diméthylglutarique ; et un milieu de dispersion,

dans laquelle la teneur en acide diméthylglutarique est comprise entre 0,05 et 1,5 % en masse par rapport à la quantité totale de particules de cuivre, et
dans laquelle la pâte de cuivre pour l'assemblage (30, 110, 110a, 110b, 110c, 110d, 110e, 120) contient des particules de cuivre submicro ayant un diamètre moyen en volume de 0,12 à 0,8 $\mu$m et des microparticules de cuivre en forme de flocons ayant un diamètre maximal de 2 à 50 $\mu$m et un rapport d'aspect de 3,0 ou plus en tant que particules de cuivre, et
dans laquelle la pâte de cuivre pour l'assemblage (30, 110, 110a, 110b, 110c, 110d, 110e, 120) contient du dihydroterpinéol comme milieu de dispersion, et
dans laquelle la teneur en particules de cuivre submicro est comprise entre 30 et 90 % en masse par rapport à la masse totale des particules de cuivre, et

la teneur en microparticules de cuivre est comprise entre 10 et 70 % en masse par rapport à la masse totale des particules de cuivre, et

dans laquelle la teneur en milieu de dispersion est de 5 à 20 % en masse par rapport à la masse totale de la pâte de cuivre à assembler, et

dans laquelle la teneur en dihydroterpinéol est égale ou supérieure à 60 % en masse par rapport à la masse totale du milieu de dispersion, et

dans laquelle la pâte de cuivre pour l'assemblage (30, 110, 110a, 110b, 110c, 110d, 110e, 120) est destinée à l'assemblage sans pression ;

dans laquelle le diamètre moyen en volume des particules signifie un diamètre moyen en volume des particules de 50 % et est mesuré selon la méthode suivante : tout d'abord, des particules métalliques servant de matière première ou des particules métalliques séchées obtenues par élimination d'un composant volatil de la pâte métallique sont dispersées dans un milieu de dispersion à l'aide d'un dispersant ; ensuite, le diamètre moyen en volume des particules de l'élément de dispersion obtenu est mesuré par un analyseur de distribution de la taille des particules selon la méthode de la diffusion de la lumière ;

et dans laquelle le diamètre maximal des microparticules de cuivre en forme de flocons est obtenu à partir d'images MEB des particules ; le diamètre maximal des microparticules de cuivre en forme de flocons est obtenu en tant qu'axe principal X de l'axe principal des microparticules de cuivre en forme de flocons ; l'axe principal X est une distance entre deux plans parallèles qui sont sélectionnés de manière à ce que la distance entre deux plans parallèles soit la plus grande parmi deux plans parallèles circonscrivant les microparticules de cuivre en forme de flocons dans la forme tridimensionnelle des microparticules de cuivre en forme de flocons.

2. Pâte de cuivre pour l'assemblage (30, 110, 110a, 110b, 110c, 110d, 110e, 120) selon la revendication 1, dans laquelle la teneur en dihydroterpinéol est de 100 % en masse sur la base de la masse totale du milieu de dispersion.

3. Méthode de fabrication d'un corps joint (80, 100, 125, 140, 150), comprenant :

une première étape de préparation d'un stratifié (50, 60, 70, 90, 95) dans lequel un premier élément (10, 102), la pâte de cuivre pour l'assemblage (30, 110, 110a, 110b, 110c, 110d, 110e, 120) selon la revendication 1 ou 2, et un deuxième élément (20, 103) sont stratifiés dans cet ordre ; et

une deuxième étape consistant à chauffer le stratifié (50, 60, 70, 90, 95) sous une atmosphère gazeuse ayant une concentration d'hydrogène inférieure ou égale à 4,5 % pour fritter la pâte de cuivre pour l'assemblage (30, 110, 110a, 110b, 110c, 110d, 110e, 120),

dans laquelle, dans la deuxième étape, la pâte de cuivre pour l'assemblage (30, 110, 110a, 110b, 110c, 110d, 110e, 120) est chauffée et frittée dans un état où elle reçoit un poids du premier élément (10, 102) ou dans un état où elle reçoit un poids du premier élément (10, 102) et une micropression inférieure ou égale à 0,01 MPa.

4. Méthode de fabrication d'un corps joint (80, 100, 125, 140, 150) selon la revendication 3, dans laquelle l'atmosphère gazeuse est une atmosphère d'azote.

5. Méthode de fabrication d'un corps joint (80, 100, 125, 140, 150) selon la revendication 3 ou 4, dans laquelle au moins l'un du premier élément (10, 102) et du deuxième élément (20, 103) est un élément semiconducteur (118).

6. Méthode de fabrication d'un corps joint (80, 100, 125, 140, 150) selon l'une des revendications 3 à 5, dans laquelle, dans le stratifié (50, 60, 70, 90, 95), le premier élément (10, 102) comporte une première électrode, le second élément (20, 103) comporte une seconde électrode faisant face à la première électrode, et la pâte de cuivre pour l'assemblage (30, 110, 110a, 110b, 110c, 110d, 110e, 120) est disposée entre la première électrode et la seconde électrode.

7. Méthode de fabrication d'un corps joint (80, 100, 125, 140, 150) selon la revendication 6, dans laquelle au moins l'une de la première électrode et de la seconde électrode est un pilier métallique (11).

8. Méthode de fabrication d'un corps joint (80, 100, 125, 140, 150) selon la revendication 6, dans laquelle le premier élément (10, 102) et le deuxième élément (20, 103) sont des puces comprenant un ou deux semiconducteurs ou plus choisis dans le groupe constitué par le silicium, le nitrure de gallium et le carbure de silicium, et la première électrode et la deuxième électrode sont des électrodes traversantes.

# *Fig.1*

(a)

(b)

# *Fig.2*

(a)

(b)

(c)

*Fig.3*

(a)

(b)

(c)

*Fig.4*

**Fig.5**

*Fig.6*

(a)

60

102
110
103

(b)

125

102
101
103

# *Fig.7*

(a)

70
118
120
115a

(b)

80
118
111
115a

(c)

130
118  117  116  115b
111  115a

**Fig.8**

# Fig.9

(a)

(b)

## Fig.10

150

104

101e
106
101d
102
101a
103

101c

105

# Fig.11

(a)

95

110e
106
110d
104
102
110c
110a
103
105

(b)

150

101e
106
101d
104
102
101c
101a
103
105

*Fig.12*

(a)

(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018170228 A
- JP 2018152176 A
- US 20160351529